# EUROPEAN PATENT APPLICATION

(11) **EP 1 895 571 A1**
(43) Date of publication of application: **05.03.2008**
(21) Application number: 06767006.7
(22) Date of filing: 20.06.2006
(51) Int. Cl.: H01L 21/027, G03F 7/20

(54) **EXPOSURE APPARATUS, EXPOSURE METHOD, MAINTENANCE METHOD AND DEVICE MANUFACTURING METHOD**

(30) Priority: 21.06.2005 JP 2005180443; 25.07.2005 JP 2005214317
(71) Applicant: NIKON CORPORATION, Tokyo 100-8331 (JP)
(72) Inventor: NAGAHASHI, Yoshitomo, NIKON CORPORATION, Tokyo 100-8331 (JP); NAKANO, Katsushi, NIKON CORPORATION, Tokyo 100-8331 (JP)
(74) Representative: Hooiveld, Arjen Jan Winfried
(86) International application number: PCT/JP2006/312347
(87) International publication number: WO 2006/137410

(57) **Abstract**

An exposure apparatus (EX) includes; a supply outlet (8) that supplies a liquid (2) to an optical path space (K) of exposure light (EL), and a liquid supply system (10) that supplies an ionized ionic liquid (2A, 2B) to the supply outlet (8).

## Description

### TECHNICAL FIELD

The present invention relates to an exposure apparatus and exposure method, a maintenance method for the exposure apparatus, and a device manufacturing method.

Priority is claimed on Japanese Patent Application Nos. 2005-180443, filed June 21, 2005, and 2005-214317, filed July 25, 2005, the contents of which are incorporated herein by reference.

### BACKGROUND ART

In the photolithography process which is one manufacturing process for micro devices (electronic devices etc.) such as semiconductor devices and the like, an exposure apparatus is used which exposes a pattern image of a mask onto a photosensitive substrate. In the manufacture of a micro device, in order to increase the density of the device, it is necessary to make the pattern formed on the substrate fine. In order to address this necessity, even higher resolution of the exposure apparatus is desired. As one means for realizing this higher resolution, there is proposed a liquid immersion exposure apparatus as disclosed in the following Patent Reference 1, in which liquid is filled in an optical path space of the exposure light, and exposure light is shone onto the substrate via the liquid, to thereby expose the substrate.

Patent Reference 1: PCT International Patent Publication No. WO 99/49504

### DISCLOSURE OF INVENTION

### PROBLEMS TO BE SOLVED BY THE INVENTION

If the liquid filling the optical path space of the exposure light is charged, there is a possibility that a disadvantage may arise where the performance of the exposure apparatus is worsened, or the performance of the manufactured device is worsened. For example, if the liquid is charged, there is a possibility of a malfunction of electrical equipment provided around the substrate, or a deterioration of the pattern formed on the substrate.

Furthermore, when the substrate is exposed via the liquid in order to form the pattern on the substrate, if bubbles are present in the liquid filling the optical path of the exposure light, there is the possibility of exposure defects such as the occurrence of faults in the pattern formed on the substrate, thus inviting a deterioration of the performance of the manufactured device.

The present invention has been made in view of such circumstances, and it is an object of the present invention to provide an exposure apparatus and an exposure method which can favorably expose a substrate. Furthermore, it is an object to provide a maintenance method which can suppress deterioration of the characteristics of the exposure apparatus. Moreover, it is an object to provide a device manufacturing method which can manufacture a device having a desired performance.

### MEANS FOR SOLVING THE PROBLEM

In order to achieve these objects, the present invention employs the following configurations summarized below in conjunction with the drawings that illustrate embodiments. In this regard, reference numerals in parentheses are attached to individual elements merely for the purpose of illustration and are not intended to limit the respective elements.

According to a first aspect of the present invention, there is provided an exposure apparatus (EX) for exposing a substrate (P), comprising: a supply outlet (8) that supplies a liquid (2) to an optical path space (K) of exposure light (EL); and a liquid supply apparatus (10) that supplies an ionized ionic liquid (2A, 2B) to the supply outlet (8).

According to the first aspect of the present invention, by supplying the ionized ionic liquid, a situation where charged liquid fills the optical path space of the exposure light can be prevented.

According to a second aspect of the present invention, there is provided an exposure apparatus (EX) for exposing a substrate (P), comprising: a first supply outlet (8A) that supplies a positive ion liquid (2A) to an optical path space (K) of exposure light (EL), and a second supply outlet (8B) that supplies a negative ion liquid (2B) to the optical path space (K).

According to the second aspect of the present invention, by supplying a positive ion liquid and a negative ion liquid, a situation where a charged liquid fills the optical path space of the exposure light can be prevented.

According to a third aspect of the present invention, there is provided an exposure apparatus (EX) for exposing a substrate (P), comprising: a first supply outlet (8A) that supplies an ionized ionic liquid (2A, 2B) to an optical path space (K) of exposure light (EL), and a second supply outlet (8B) that supplies a non ionized non ionic liquid (2P) to the optical path space (K).

According to the third aspect of the present invention, by supplying the ionic liquid and the non ionic liquid, a situation where a charged liquid fills the optical path space of the exposure light can be prevented.

According to a fourth aspect of the present invention, there is provided an exposure apparatus (EX) for exposing a substrate (P), comprising: an immersion mechanism (1) that fills an optical path space (K) of exposure light (EL) with a liquid (2), and a cleaning mechanism (1) that cleans a predetermined member (FL, 6) being in contact with the liquid (2), with an ionized ionic liquid (2A, 2B).

According to the fourth aspect of the present invention, by cleaning the predetermined member with ionic liquid, deterioration of the performance of the exposure apparatus can be suppressed.

According to a fifth aspect of the present invention, there is provided a device manufacturing method that uses the exposure apparatus (EX) of the abovementioned aspects.

According to the fifth aspect of the present invention, a device having desired performance can be manufactured.

According to a sixth aspect of the present invention, there is provided an exposure method for exposing a substrate (P), the method comprising: supplying an ionized ionic liquid (2A, 2B) to an optical path space (K) of exposure light (EL); and irradiating the substrate (P) with the exposure light (EL) via a liquid (2), the liquid being filled in the optical path space (K).

According to the sixth aspect of the present invention, by supplying the ionized ionic liquid, a situation where a charged liquid fills the optical path space of the exposure light can be prevented.

According to a seventh aspect of the present invention, there is provided a device manufacturing method that uses the exposure method of the above aspects.

According to the seventh aspect of the present invention, a device having desired performance can be manufactured.

According to an eighth aspect of the present invention, there is provided a maintenance method for an exposure apparatus (EX) that exposes a substrate (P), the method comprising: cleaning a predetermined member (FL) with an ionized ionic liquid (2A), the member being in contact with a liquid (2) filled in an optical path space (K) of exposure light (EL).

According to the eighth aspect of the present invention, by cleaning the predetermined member with ionic liquid, deterioration of the performance of the exposure apparatus can be suppressed.

According to a ninth aspect of the present invention, there is provided an exposure apparatus (EX) for exposing a substrate (P), comprising: an immersion mechanism (6, etc.) that fills an optical path space (K) of exposure light (EL) with a liquid (2), and an antistatic device (e.g., 14) that prevents a charge of bubbles, the bubbles being generated in the liquid (2).

According to the ninth aspect of the present invention, even in the case where bubbles are generated in the liquid, charging which obstructs the reduction or elimination of the bubbles in the liquid is prevented. Therefore the occurrence of defective exposure due to bubbles in the liquid is suppressed, and the substrate can be satisfactorily exposed.

According to a tenth aspect of the present invention, there is provided an exposure apparatus (EX) for exposing a substrate (P), comprising: an immersion mechanism (e.g., 6) that fills an optical path space (K) of exposure light (EL) with a liquid (2), and an antistatic device (e.g., 14) that prevents a charge of the liquid (2) to thereby suppress defective exposure due to bubbles in the liquid (2).

According to the tenth aspect of the present invention, since the antistatic device that prevents a charge of the liquid is provided, then even in the case where bubbles are generated in the liquid, charging of the bubbles which obstructs the reduction or elimination of the bubbles, can be suppressed. Therefore the occurrence of defective exposure due to bubbles in the liquid is suppressed, and the substrate can be satisfactorily exposed.

According to an eleventh aspect of the present invention, there is provided an exposure apparatus (EX) for exposing a substrate (P), comprising: an immersion mechanism (e.g., 6) that fills an optical path space (K) of exposure light (EL) with a liquid (2), and a prevention apparatus (e.g., 14) that prevents defective exposure due to charged bubbles in the liquid (2).

According to the eleventh aspect of the present invention, since defective exposure due to charged bubbles in the liquid is prevented, the substrate can be satisfactorily exposed.

According to a twelfth aspect of the present invention, there is provided a device manufacturing method that uses the exposure apparatus (EX) of the abovementioned aspects.

According to the twelfth embodiment of the present invention, a device having a desired performance can be manufactured.

According to a thirteenth aspect of the present invention, there is provided an exposure method for exposing a substrate (P), comprising: supplying a liquid (2) to an optical path space (K) of exposure light (EL), preventing bubbles in the liquid (2) being charged to thereby suppress defective exposure due to bubbles in the liquid (2) in the optical path space (K).

According to the thirteenth aspect of the present invention, even in the case where bubbles are generated in the liquid, charging which obstructs the reduction or elimination of the bubbles in the liquid is prevented. Therefore the occurrence of defective exposure due to bubbles in the liquid is suppressed, and the substrate can be satisfactorily exposed.

According to a fourteenth aspect of the present invention, there is provided an exposure method for exposing a substrate (P), comprising: supplying a liquid (2) to an optical path space (K) of exposure light (EL), and preventing charging of the liquid (LQ) to thereby suppress defective exposure due to bubbles in the liquid (2) in the optical path space (K).

According to the fourteenth aspect of the present invention, by preventing a charge of the liquid, then even in the case where bubbles are generated in the liquid, the charge of the bubbles in the liquid which obstructs the reduction or elimination of the bubbles can be suppressed. Therefore the occurrence of defective exposure due to bubbles in the liquid is suppressed, and the substrate can be satisfactorily exposed.

According to a fifteenth aspect of the present invention, there is provided a device manufacturing method that uses the exposure method of the above aspects.

According to the fifteenth aspect of the present invention, a device having a desired performance can be manufactured.

### BRIEF DESCRIPTION OF THE DRAWINGS

FIG. 1 is a schematic block diagram of an exposure apparatus according to a first embodiment.
FIG. 2 is a view of a nozzle member from below.
FIG. 3 is a diagram for explaining a liquid supply system according to the first embodiment.
FIG. 4 is a schematic diagram for explaining one example of an ion water production apparatus.
FIGS. 5A and 5B are diagrams showing an example of a substrate.
FIG. 6 is a diagram for explaining an example of a charge removal device.
FIG. 7 is a diagram for explaining a liquid supply system according to a second embodiment.

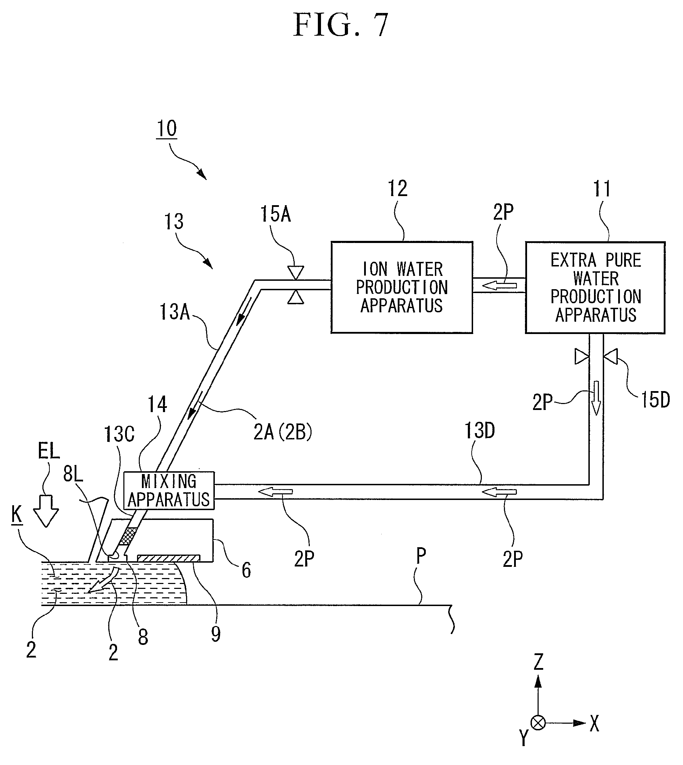

FIG. 7 is a diagram for explaining a liquid supply system according to the second embodiment.

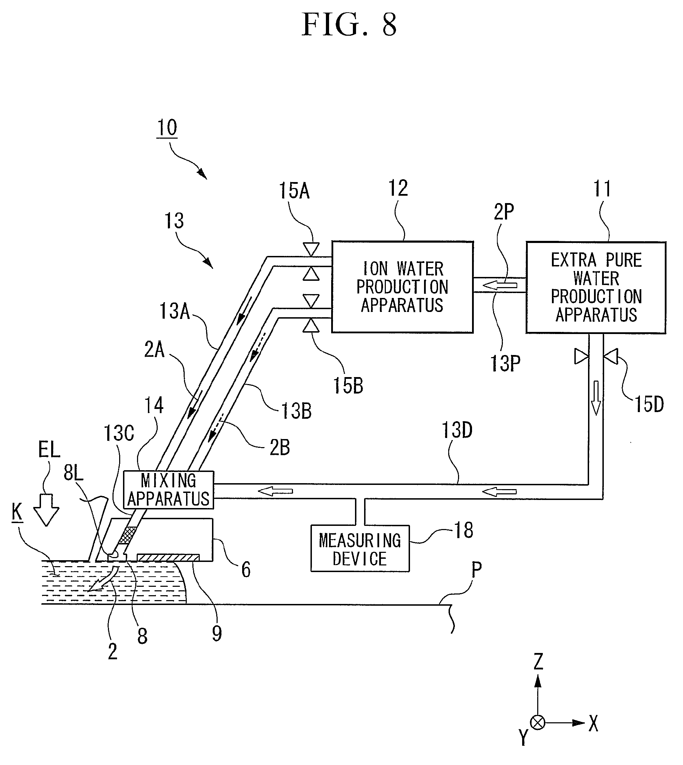

FIG. 8 is a diagram for explaining a liquid supply system according to a third embodiment.

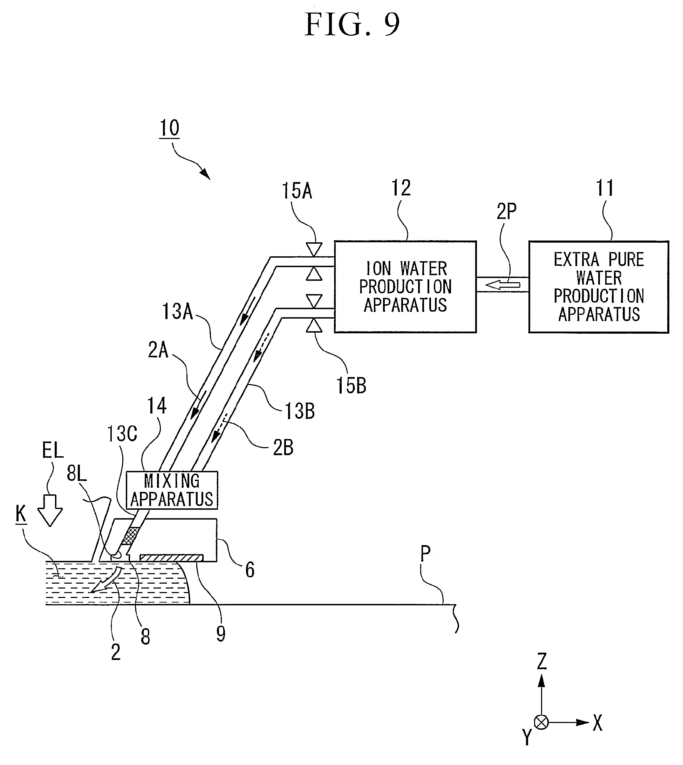

FIG. 9 is a diagram for explaining a liquid supply system according to a fourth embodiment.

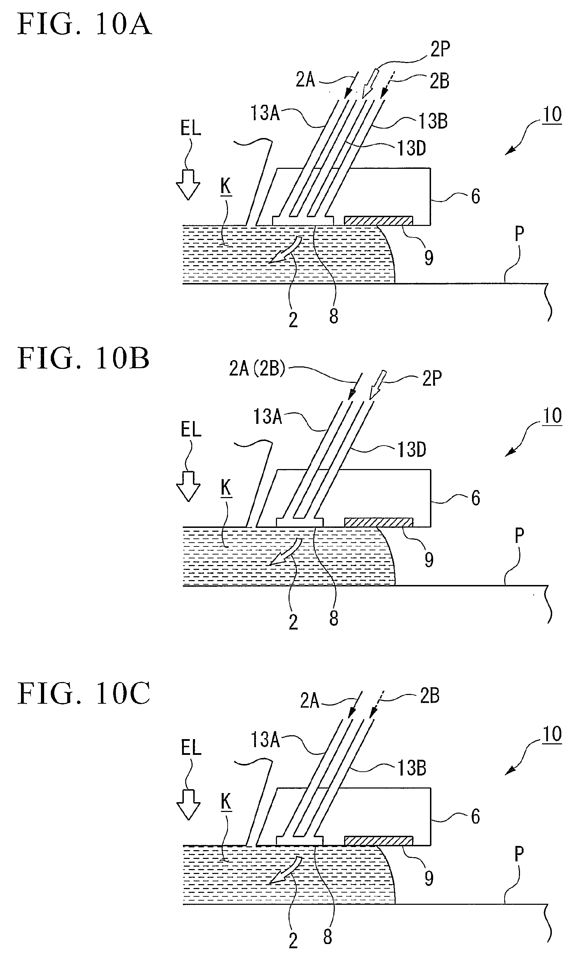

FIGS. 10A, 10B, and 10C are diagrams for explaining a liquid supply system according to a fifth embodiment.

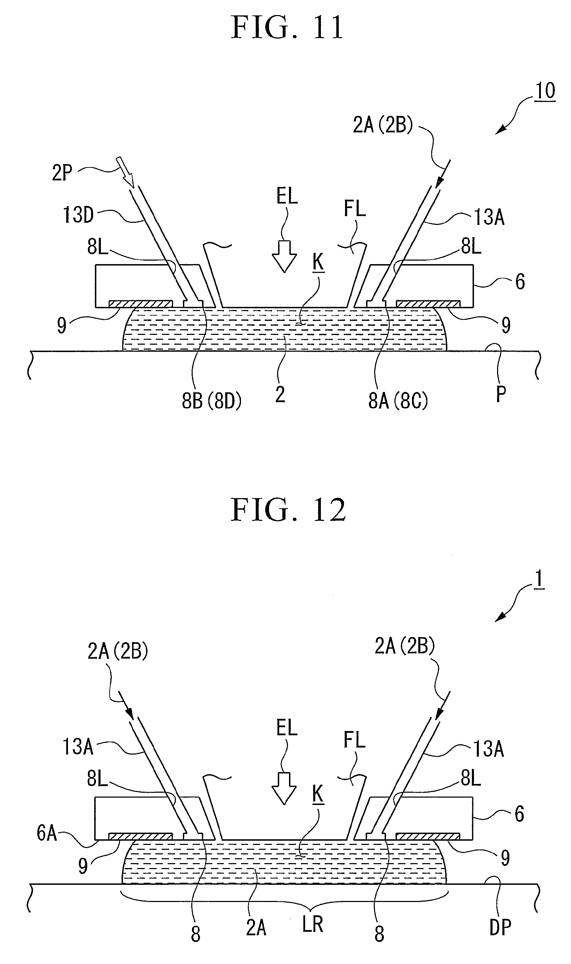

FIG. 11 is a diagram for explaining a liquid supply system according to a sixth embodiment.
FIG. 12 is a diagram for explaining an operation according to a seventh embodiment.

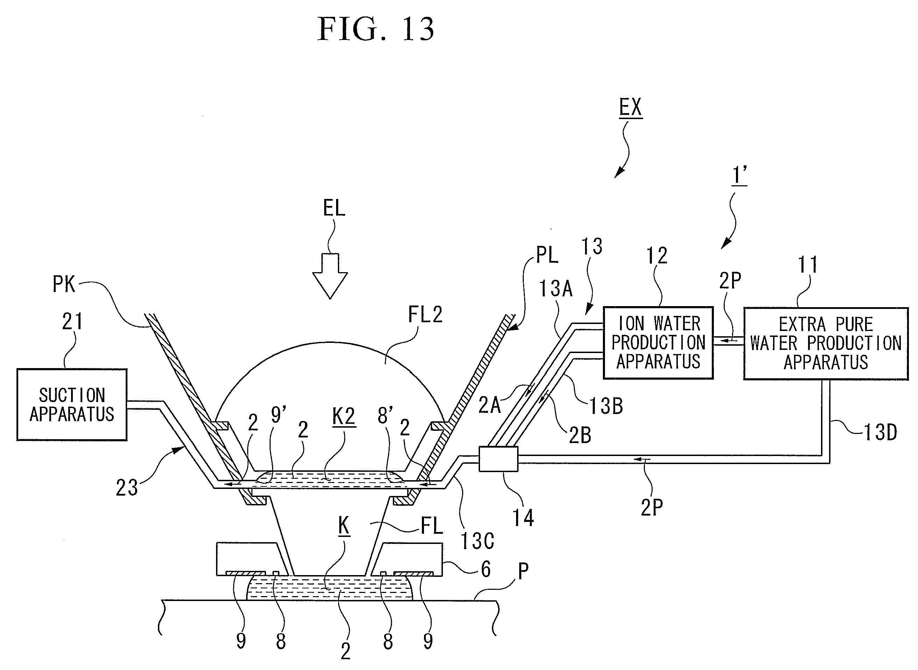

FIG. 13 is a diagram for explaining an exposure apparatus according to an eighth embodiment.

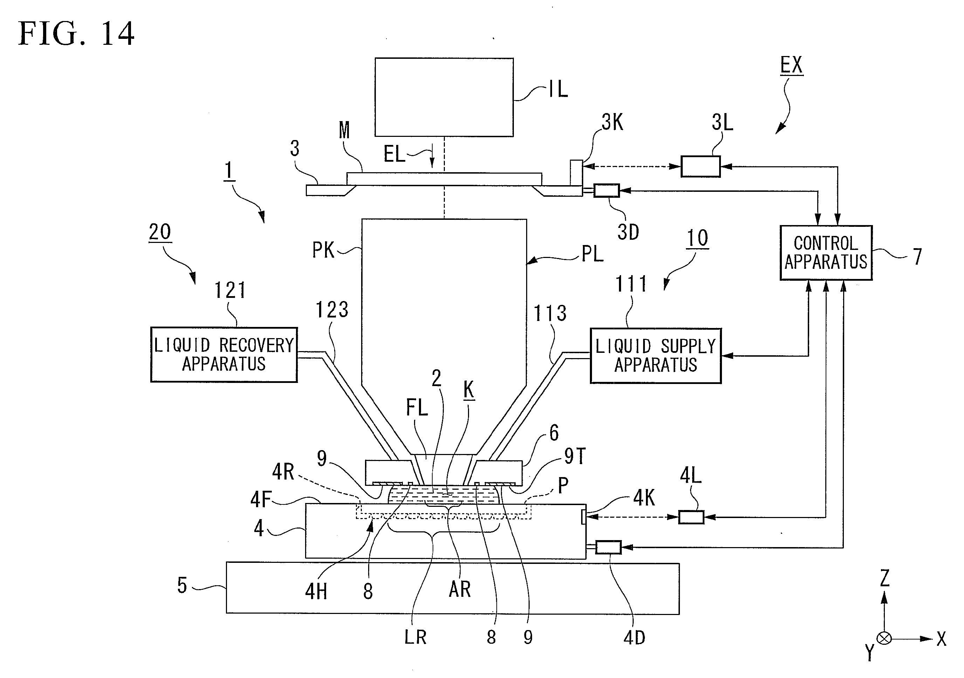

FIG. 14 is a schematic block diagram showing an exposure apparatus according to a ninth embodiment.

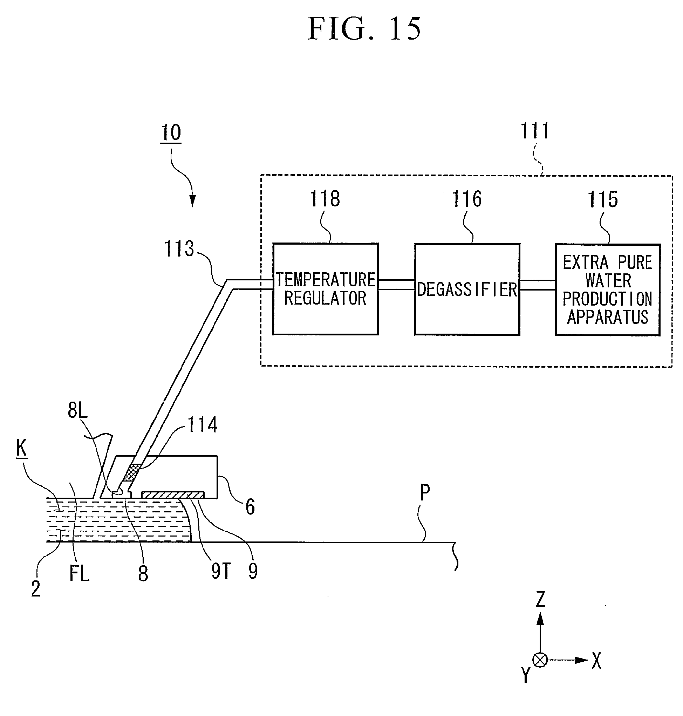

FIG. 15 is a diagram for explaining a liquid supply system according to the ninth embodiment.

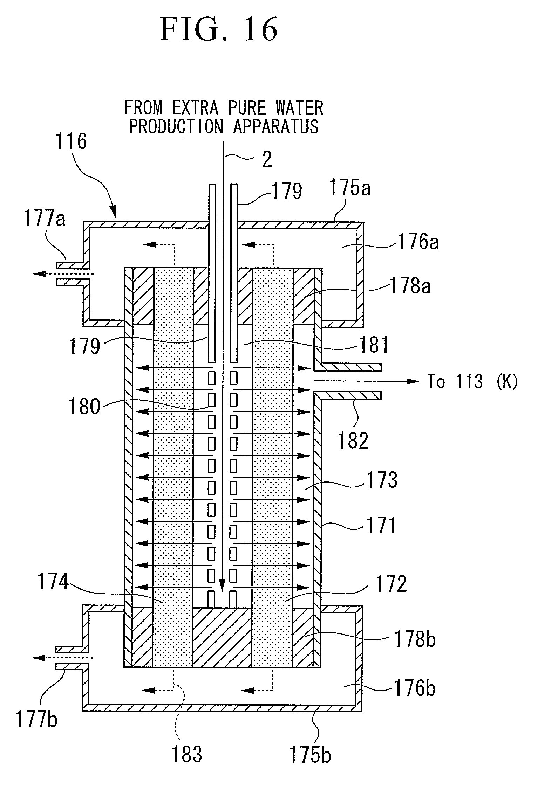

FIG. 16 is a diagram for explaining one example of a degassing apparatus.

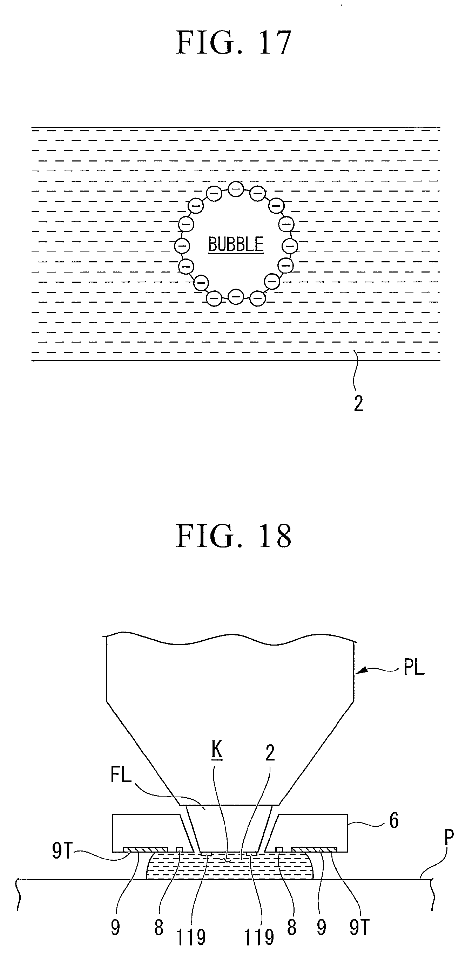

FIG. 17 is a schematic diagram for explaining an aspect where bubbles are charged.
FIG. 18 is a diagram showing an exposure apparatus according to a tenth embodiment.

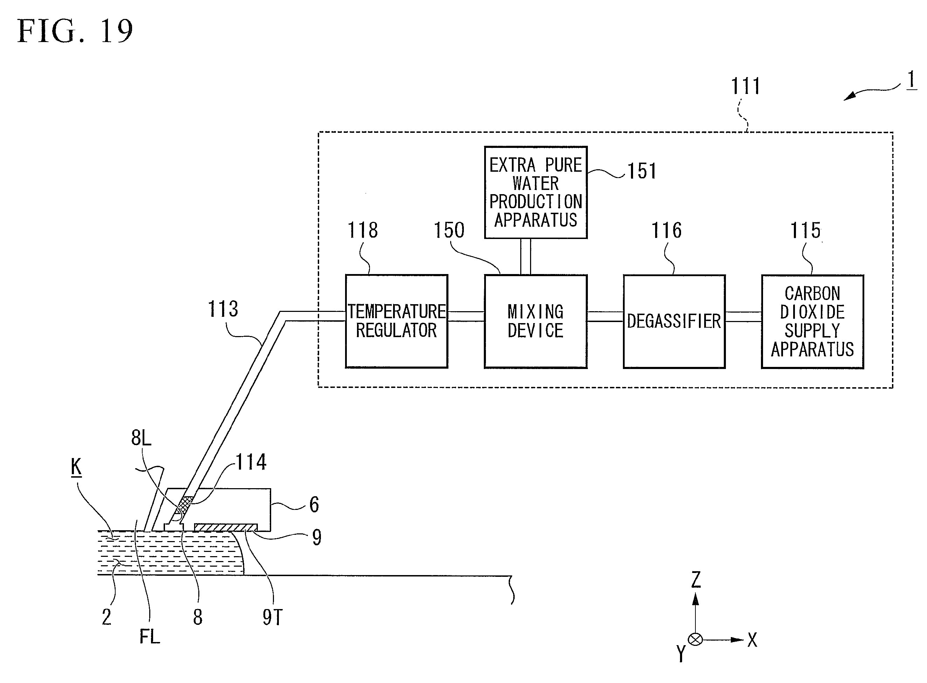

FIG. 19 is a diagram for explaining a liquid supply system according to an eleventh embodiment.

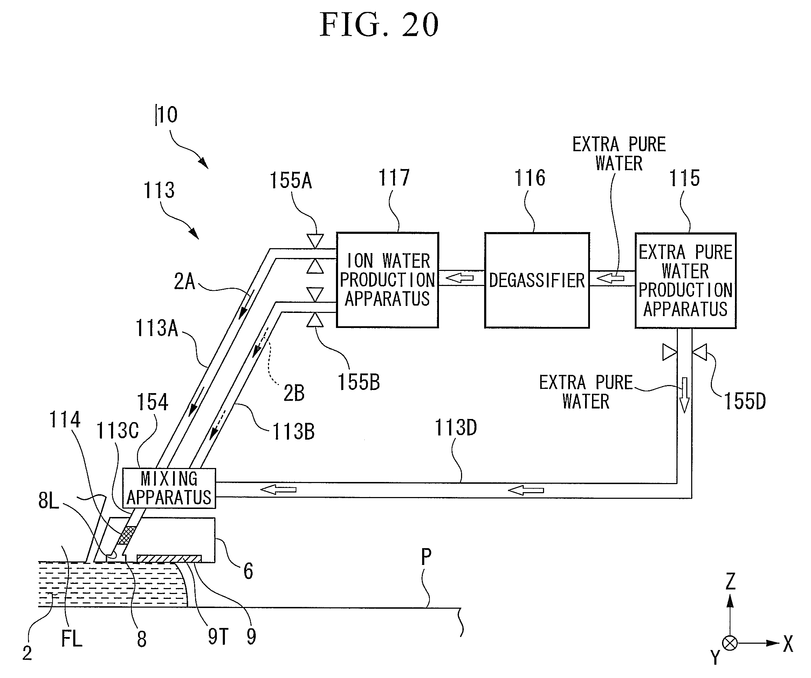

FIG. 20 is a diagram for explaining a liquid supply system according to a twelfth embodiment.

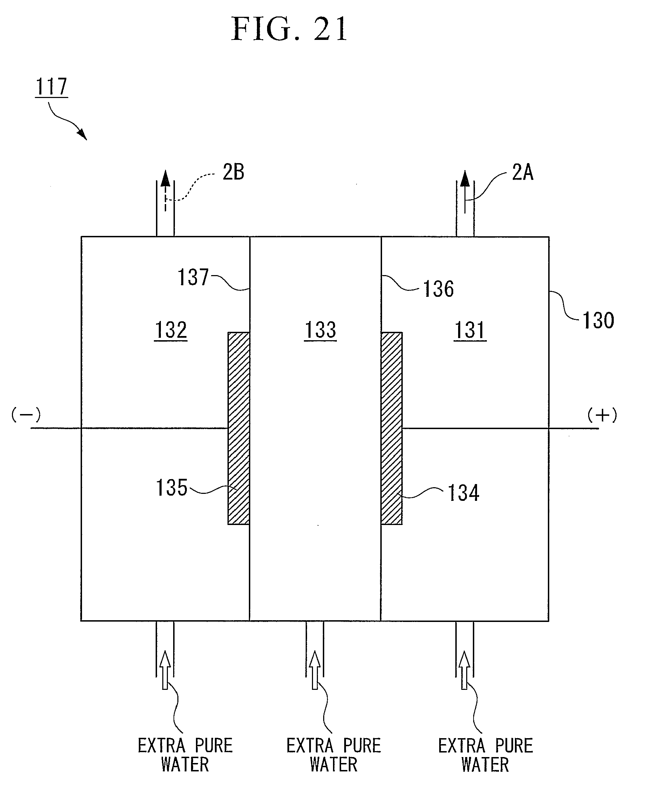

FIG. 21 is a diagram for explaining one example of an ion water production apparatus.

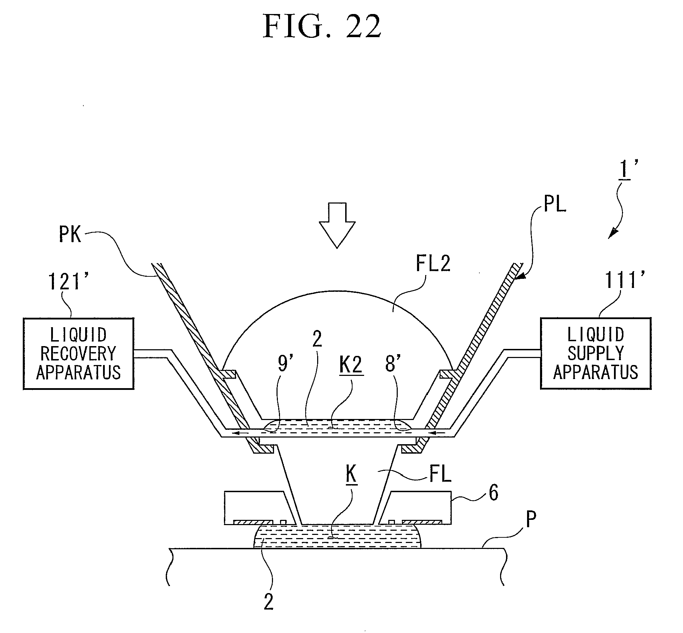

FIG. 22 is a diagram showing an exposure apparatus according to a thirteenth embodiment.

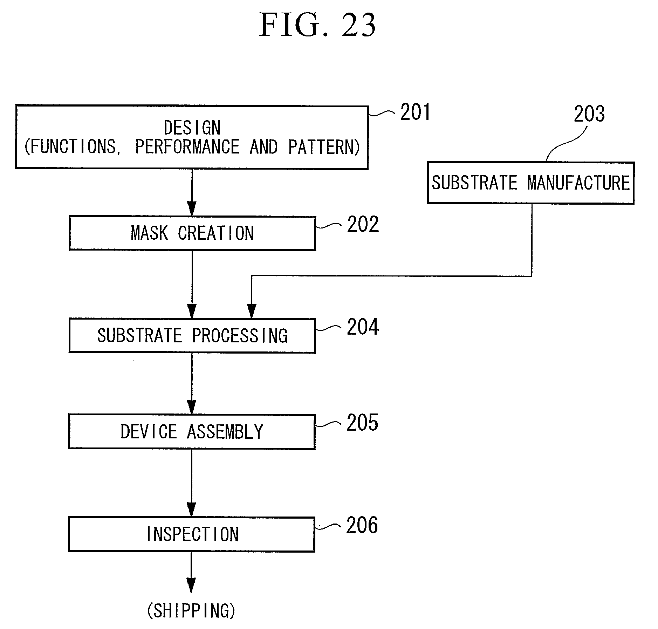

FIG. 23 is a flow chart for explaining an example of manufacturing steps for a micro device.

### DESCRIPTION OF THE REFERENCE SYMBOLS

1 : IMMERSION SYSTEM (IMMERSION MECHANISM, CLEANING MECHANISM), 2 : LIQUID, 2A : ANODE WATER (POSITIVE ION WATER), 2B : CATHODE WATER (NEGATIVE ION WATER), 2P : EXTRA PURE WATER (NON IONIC LIQUID), 6 : NOZZLE MEMBER (PASSAGE FORMING MEMBER), 7 : CONTROL APPARATUS, 8 (8A-8D): SUPPLY PORT, 10 : LIQUID SUPPLY SYSTEM (LIQUID SUPPLY APPARATUS) 12 : ION WATER PRODUCTION APPARATUS (IONIC LIQUID PRODUCTION APPARATUS), 13 : SUPPLY PIPE SYSTEM, 14 : MIXING APPARATUS, 114 : CHARGE REMOVAL FILTER, 116 : DEGASSIFIER, 117 : ION WATER PRODUCTION APPARATUS, 119 CONDUCTING MEMBER, 150 : MIXING DEVICE, 151 : CARBON DIOXIDE SUPPLY APPARATUS, 154 : MIXING APPARATUS, EL: EXPOSURE LIGHT, EX : EXPOSURE APPARATUS, FL : FINAL OPTICAL ELEMENT (OPTICAL MEMBER), FL2 : BOUNDARY OPTICAL ELEMENT (OPTICAL MEMBER), K (K2) : OPTICAL PATH SPACE, P: SUBSTRATE

### BEST MODE FOR CARRYING OUT THE INVENTION

Hereunder is a description of embodiments of the present invention with reference to the drawings. However the present invention is not limited to this description. In the following description, an XYZ rectangular co-ordinate system is established, and the positional relationship of respective members is described with reference to this XYZ rectangular co-ordinate system. A predetermined direction within a horizontal plane is made the X axis direction, a direction orthogonal to the X axis direction in the horizontal plane is made the Y axis direction, and a direction orthogonal to both the X axis direction and the Y axis direction (that is, a perpendicular direction) is made the Z axis direction. Furthermore, rotation (inclination) directions about the X axis, the Y axis and the Z axis, are made the θ X, the θ Y, and the θ Z directions respectively.

### <First embodiment>

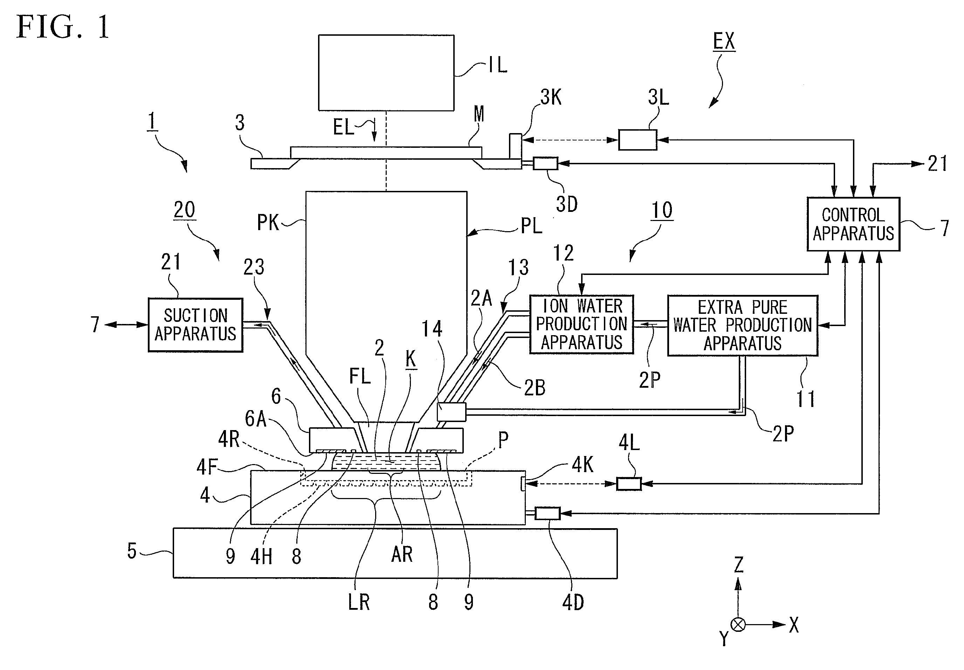

A first embodiment will be explained. FIG. 1 is a schematic block diagram showing an exposure apparatus EX according to a first embodiment. In FIG. 1, the exposure apparatus EX includes; a mask stage 3 capable of holding and moving a mask M, a substrate stage 4 capable of holding and moving a substrate P, an illumination optical system IL for illuminating a mask M held on the mask stage 3 with exposure light EL, a projection optical system PL for projecting a pattern of the mask M illuminated by the exposure light EL onto the substrate P, and a control apparatus 7 for controlling operation of the whole exposure apparatus EX. The substrate here includes one a sensitive material (photoresist) is spread on a substrate of a semiconductor wafer or the like, and includes a reticule formed with a device pattern which is reduction size projected onto the substrate. In the present embodiment, a transmission mask is used as the mask, however a reflecting mask may be used.

The exposure apparatus EX of the present embodiment is an immersion exposure apparatus applicable to an immersion method for substantially shortening the exposure length and improving the resolution, and also substantially expanding the depth of focus. It includes at least; an immersion system 1 which fills an optical path space K of exposure light EL on an image surface of a projection optical system PL with a liquid 2. Operation of the immersion system 1 is controlled by a control apparatus 7. The exposure apparatus EX uses the immersion system 1 during exposure of the pattern of the mask M at least onto the substrate P, to fill the optical path space K of the exposure light EL with the liquid 2. The exposure apparatus EX illuminates exposure light EL which has passed through the mask M via the projection optical system PL and the liquid 2 which is filled in the optical path space K, onto substrate P, to thereby expose the pattern image of the mask M onto the substrate P. Furthermore, the exposure apparatus EX of the present embodiment adopts a local liquid immersion method where the liquid 2 which fills the optical path space K locally forms an immersion region LR which is greater than a projection region AR, and smaller than the substrate P, on a region of one part of the substrate P which includes the projection region AR of the projection optical system PL.

In the present embodiment, the case where mainly the immersion region LR is formed on the substrate P is described. However on the image surface side of the projection optical system PL, of a plurality of optical elements of the projection optical system PL, the immersion region LR can also be formed on an object which is arranged at a position opposite to the final optical element FL nearest to the image surface of the projection optical system PL, for example on one part of the substrate stage 4 or the like.

The illumination optical system IL is one which illuminates a predetermined illumination region on the mask M with exposure light EL of a uniform luminance distribution. For the exposure light EL radiated from the illumination optical system IL, for example emission lines (g-ray, h-ray, i-ray), radiated for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength:193nm) and the F₂ laser beam (wavelength: 157nm), may be used. In this embodiment, the ArF excimer laser beam is used.

The mask stage 3 is moveable in the X axis, and the θZ direction in a condition holding the mask M, by means of drive from a mask stage driving device 3D which includes an actuator such as a linear motor. Position information of the mask stage 3 (and consequently the mask M) is measured by a laser interferometer 3L. The laser interferometer 3L uses a movement mirror 3K which is provided on the mask stage 3 to measure the position information of the mask stage 3. The control apparatus 7 controls the mask stage driving device 3D based on the measured results of the laser interferometer 3L, and controls the position of the mask M which is held in the mask stage 3.

The movement mirror 3K may include not only a plane mirror, but also a corner cube (retroreflector), and instead of securing the movement mirror 3K to the mask stage 3, a mirror surface may be used which is formed by mirror polishing for example the end face (side face) of the mask stage 3. Furthermore, the mask stage 3 may be of a construction capable of coarse/fine movement as disclosed for example in Japanese Unexamined Patent Application, First Publication No. H8-130179 (corresponding U.S. Patent No. 6,721,034).

The projection optical system PL is one which projects a pattern image of the mask M onto the substrate P at a predetermined projection magnification, and has a plurality of optical elements, and these optical elements are held in a lens barrel PK. The projection optical system PL is a reduction system with a projection magnification of for example 1/4, 1/5, 1/8 or the like, and forms a reduced image of the mask pattern on the aforementioned illumination region and the conjugate projection region AR. The projection optical system PL may be a reduction system, an equal system or a magnification system. Furthermore, the projection optical system PL may include any one of; a refractive system which does not include a reflection optical element, a reflection system which does not include a refractive optical element, or a cata-dioptric system which includes a reflection optical system and a refractive optical system. Moreover, the projection optical system PL may form either an inverted image or an erect image. Furthermore, in the present embodiment, of the plurality of optical elements of the projection optical system PL, only the final optical element FL which is closest to the image surface of the projection optical system PL is contacted with the liquid 2 of the optical path space K.

The substrate stage 4 has a substrate holder 4H for holding the substrate P, and is capable of holding the substrate P held on the substrate holder 4H and moving above a base member 5. The substrate holder 4H is arranged in a recess portion 4R which is provided in the substrate stage 4, and an upper surface 4F of the substrate stage 4 other than the recess portion 4R becomes a flat surface of approximately the same height (flush) as the surface of the substrate P which is held in the substrate holder 4H. This is because a part of the immersion region LR which runs out from the surface of the substrate P is formed on the upper surface 4F, at for example the time of the exposure operation of the substrate P. Only one part of the upper surface 4F of the substrate stage 4, for example, a predetermined region surrounding the substrate P (including the region where the immersion region LR runs out), may be approximately the same height as the surface of the substrate P. Furthermore, if the optical path space K on the image surface side of the projection optical system PL is continuously filled with the liquid 2 (for example the immersion region LR can be favorably maintained), then there may be a step between the surface of the substrate P which is held in the substrate holder 4H, and the upper surface 4F of the substrate stage 4. Furthermore, the substrate holder 4H may be formed as one with one part of the substrate stage 4. However, in the present embodiment, the substrate holder 4H and the substrate stage 4 are made separate, and the substrate holder 4H is secured in the substrate stage 4 by, for example, vacuum attraction.

The substrate stage 4 is moveable in a direction of six degrees of freedom of; the X axis, the Y axis, the Z axis, the θX, the θY and the θZ directions, in a condition with the substrate P held, by means of drive from a substrate stage driving device 4D which includes an actuator such as a linear motor. Position information of the substrate stage 4 (and consequently the substrate P) is measured by a laser interferometer 4L. The laser interferometer 4L uses a movement mirror 4K which is provided on the substrate stage 4 to measure the position information of the substrate stage 4 in relation to the X axis, the Y axis, and the θZ directions. Furthermore, surface position information of the surface of the substrate P held in the substrate stage 4 (position information related to the Z axis, the θX, and the θY directions) is detected by a focus leveling detection system (not shown in the figure). The control apparatus 7 drives the substrate stage driving device 4D based on the detection results of the laser interferometer 4L, and the detection results of the focus leveling detection system, to control the position of the substrate P which is held in the substrate stage 4.

The laser interferometer 4L may also be capable of measuring the position in the Z axis direction of the substrate stage 4, and the rotation information in the θX and the θY directions. More detail of this is disclosed for example in Japanese Unexamined Patent Application, First Publication No. 2001-510577 (corresponding PCT International Publication No. 1999/28790). Furthermore, instead of fixing the movement mirror 4K to the substrate stage 4, a reflection surface may be used where for example a part of the substrate stage 4 (the side face or the like) is formed by a mirror polishing process.

Furthermore, the focus leveling detection system is one which detects inclination information (rotation angle) for the θX and the θY directions of the substrate P by measuring position information for a plurality of measurement points for the Z axis direction of the substrate P. Regarding this plurality of measurement points, at least one part may be set within the immersion region LR (or the projection region AR), or all of these may be set on the outside of the immersion region LR. Moreover, when for example the laser interferometer 4L is capable of measuring the position information for the Z axis, the θX, and the θY directions of the substrate P, then it is possible to measure the position information for the Z axis direction during the exposure operation of the substrate P, and hence the focus leveling detection system need not be provided, and position control of the substrate P in relation to the Z axis, the θX, and the θY directions can be performed using the measurement results of the laser interferometer 4L, at least during the exposure operation.

Next is a description of the immersion system 1. The immersion system 1 fills an optical path space K of the exposure light EL between the final optical element FL of the projection optical system PL, and the substrate P which is arranged at a position corresponding to the final optical element FL, on the image side of the projection optical system PL, with a liquid 2. In the present embodiment, water (pure water) is used as the liquid 2.

The immersion system 1 includes: supply ports 8 provided at a predetermined position with respect to the optical path space K of the exposure light EL for supplying liquid 2 to the optical path space K of the exposure light EL; a nozzle member 6 having a collection port 9 for recovering the liquid 2; a liquid supply system 10 for supplying liquid 2 to the supply ports 8; and a liquid recovery system 20 for recovering the liquid 2 via the recovering port 9. The control apparatus 7 controls the immersion system 1, and by performing a supply operation for the liquid 2 via the supply ports 8, and a recovery operation for the liquid 2 via the collection port 9, the optical path space K of the exposure light EL is filled with the liquid 2, and an immersion region LR of the liquid 2 is locally formed on a region of one portion on the substrate P.

The liquid supply system 10 includes: an extra pure water production apparatus 11 for producing extra pure water 2P; an ion water production apparatus 12 for ionizing the extra pure water 2P produced by the extra pure water production apparatus 11, and producing ion water 2A and 2B; and a supply pipe system 13 for supplying the ion water 2A and 2B produced by the ion water production apparatus 12 to the supply ports 8 of the nozzle member 6. In the interior of the nozzle member 6 there is formed an internal passage (supply passage) for connecting between the supply port 8 and the supply pipe system 13. The supply passage of the nozzle member 6 in which the liquid 2 flows, is connected to the optical path space K via the supply port 8. Furthermore, while not shown in the figure, the liquid supply system 10 also includes; a temperature regulator for regulating the temperature of the liquid 2 for supply, a degassifier for reducing the gas content in the liquid 2 for supply, and a filter system for removing foreign materials from the liquid 2, and so on, and is capable of supplying clean temperature adjusted liquid 2.

The liquid recovery system 20 includes a suction apparatus 21 which contains a suction system of a suction pump or the like which sucks and recovers the liquid 2 via the collection port 9 of the nozzle member 6, and a recovery piping system 23. Inside the nozzle member 6 is formed an internal passage (recovery passage) which connects between the collection port 9 and the recovery piping system 23. The recovery passage of the nozzle member 6 through which the liquid 2 flows, is connected to the optical path space K by the collection port 9.

Equipment which constitutes at least a part of the liquid supply system 10 or the liquid recovery system 20 may be substituted for equipment of for example a factory in which the exposure apparatus EX is installed.

The nozzle member 6 is formed in an annular shape so as to surround the final optical element FL nearest to the image surface of the projection optical system PL, of the optical elements of the projection optical system PL. In the present embodiment, the supply ports 8 for supplying the liquid 2, and the collection port 9 for recovering the liquid 2 are formed in the bottom surface 6A of the nozzle member 6.

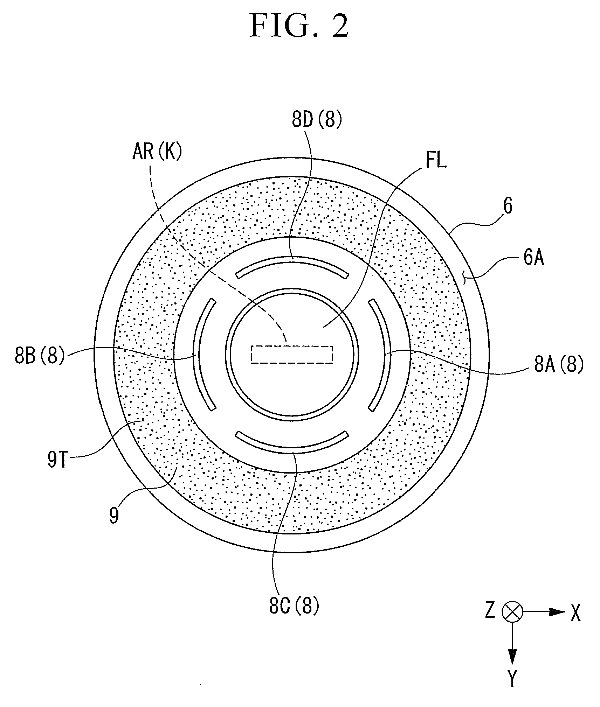

FIG. 2 shows the nozzle member 6 viewed from the bottom surface 6A side. The nozzle member 6 is an annular shape member which is provided so as to surround at least one optical element (in the present example the final optical element FL) which is arranged on the image surface side of the projection optical system PL. The supply ports 8 (8A to 8D) are respectively provided in the bottom surface 6A of the nozzle member 6, at a plurality of predetermined positions so as to surround the final optical element FL (the optical path space K) of the projection optical system PL. In the present embodiment, four supply ports 8A to 8D are provided in the nozzle member 6. Each of the supply ports 8A to 8D is formed in a slit shape of a circular arc seen in a plane.

Furthermore, the collection port 9 is provided in the bottom surface 6A of the nozzle member 6, on the outside from the supply ports 8 with respect to the final optical element FL, and is provided in an annular shape so as to surround the final optical element FL and the supply ports 8. In the present embodiment, in the collection port 9 is arranged a mesh member made for example from titanium, or stainless steel (for example SUS316), or a porous member 9T including a porous body or the like made from ceramics.

In the present embodiment, the immersion system 1 is provided so as to recover only the liquid 2 via the collection port 9 (porous member 9T) by optimizing the difference between the pressure of the recovery path provided on the inside of the nozzle member 6, and the pressure of the external space (atmosphere space) (the difference between the pressure on one side face of the porous member 9T, and the pressure on the other side face), corresponding to the diameter of the holes of the porous member 9T, the contact angle between the porous member 9T and the liquid 2, and the surface tension of the liquid 2, and so on. More specifically, the immersion system 1 recovers only the liquid 2 by controlling the suction pressure with respect to the recovery path by means of the suction apparatus 21, and optimizing the pressure of the recovery path. As a result, the occurrence of vibrations attributable to the liquid 2 and air being sucked together can be suppressed.

The control apparatus 7 fills the optical path space K with the liquid 2 by concurrently performing a supply operation for the liquid 2 via the supply ports 8, and a recovery operation for the liquid 2 via the collection port 9, and locally forms an immersion region LR of the liquid 2 in a region of one part on the substrate P.

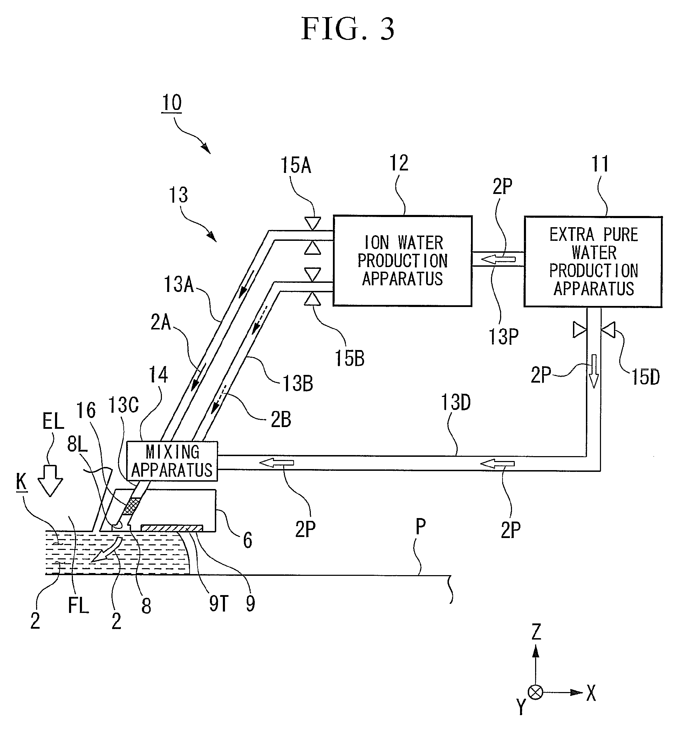

FIG. 3 is a diagram for explaining the liquid supply system 10. In FIG. 3, the liquid supply system 10 includes: an extra pure water production apparatus 11 for producing extra pure water 2P; an ion water production apparatus 12 for ionizing the extra pure water 2P produced by the extra pure water production apparatus 11, and producing ion water 2A and 2B; and a supply pipe system 13 for supplying the ion water 2A and 2B produced by the ion water production apparatus 12 to the supply ports 8 of the nozzle member 6. The supply pipe system 13 includes: a connection pipe 13P, a first supply pipe 13a, and second supply pipe 13B, a third supply pipe 13C, and a fourth supply pipe 13D. In the interior of the nozzle member 6 there is formed an internal passage (supply passage) 8L for connecting between the supply port 8 and the supply pipe system 13 (third supply pipe 13 C).

The extra pure water production apparatus 11 cleans the water to produce extra pure water 2P. The extra pure water 2P produced by the extra pure water production apparatus 11 is sent to the ion water production apparatus 12 via the connection pipe 13P.

The ion water production apparatus 12 ionizes the extra pure water 2P and produces positive ion water 2A and negative ion water 2B. In the following description, the positive ion water 2A is appropriately called anode water 2A, and the negative ion water 2B is appropriately called cathode water 2B. Compared to the extra pure water 2P before being ionized, the anode water 2A contains a large amount of hydrogen ions (H⁺), and the cathode water 2B contains a large amount of hydroxyl ions (OH⁻).

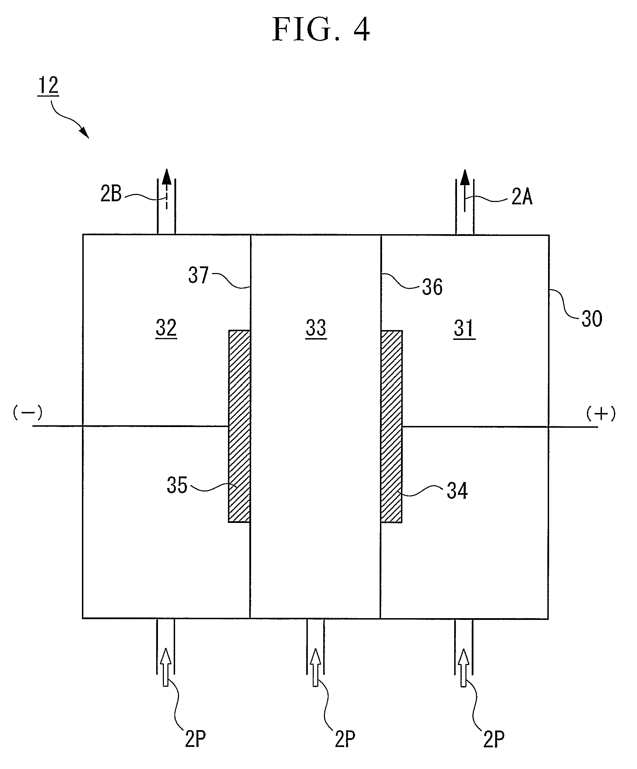

FIG. 4 is a schematic diagram showing an example of the ion water production apparatus 12. The ion water production apparatus 12 has an electrolytic bath 30 to which the extra pure water 2P is supplied. The interior of the electrolytic bath 30 is partitioned into first, second, and third chambers 31, 32 and 33 by means of diaphragms (ion exchange membranes) 36 and 37. The extra pure water 2P is respectively supplied to the first, second and third chambers 31, 32 and 33. An anode 34 is arranged in the first chamber 31, and a cathode 35 is arranged in the second chamber 32. The third chamber 33 is provided between the first chamber 31 and the second chamber 32, and is filled for example with an ion exchange membrane. By supplying extra pure water 2P to the first, second, and third chambers 31, 32 and 33, and applying a voltage to the anode 34 and the cathode 35, the anode water 2A is produced in the first chamber 31, and the cathode water 2B is produced in the second chamber 32. In this manner, the ion water production apparatus 12 can produce the electrolytic ion water 2A and 2B by electrolyzing the extra pure water 2P. To the extra pure water 2P supplied to the electrolytic bath 30, or the ion water sent from the electrolytic bath 30, a predetermined electrolyte may be added. The ion water production apparatus 12 shown in FIG. 4 is but one example, and provided the ion water 2A and 2B can be produced, an optional construction can be adopted.

Returning to FIG. 3, the liquid supply system 10 includes a first supply pipe 13A for supplying the anode water 2A produced by the ion water production apparatus 12 to the supply ports 8, and a second supply pipe 13B for supplying the cathode water 2B. Furthermore, the liquid supply system 10 includes a mixing apparatus 14 for mixing the anode water 2A supplied by the first supply pipe 13A, and the cathode water 2B supplied by the second supply pipe 13B. The mixing apparatus 14 is provided in the vicinity of the nozzle member 6 which has the supply port 8. The mixing apparatus 14 and a supply passage 8L provided inside the nozzle member 6 are connected via a third supply pipe 13C. Consequently, the supply ports 8 and the mixing apparatus 14 are connected via the third supply pipe 13C and the supply passage 8L. The liquid 2 produced by the mixing apparatus 14 is supplied to the supply ports 8 via the third supply pipe 13C, and the supply passage 8L. In this manner, the liquid supply system 10 uses the supply pipe system 13 including the first and second supply pipes 13A and 13B, and each of the anode water 2A and the cathode water 2B are connected to the supply ports 8 via the mixing apparatus 14. The liquid 2 which is supplied to the supply ports 8 via supply pipe system 13 is supplied to the optical path space K by the supply ports 8.

Furthermore, the liquid supply system 10 includes a fourth supply pipe 13D for connecting the extra pure water production apparatus 11 and the mixing apparatus 14. The fourth supply pipe 13D supplies extra pure water 2P which is produced by the extra pure water production apparatus 11 but is not ionized, to the mixing apparatus 14.

Moreover, part way along the first supply pipe 13A there is provided an adjustment mechanism 15A for adjusting the amount (supply amount per unit time) of the anode water 2A supplied to the mixing apparatus 14, which is produced by the ion water production apparatus 12. Similarly, part way along the second supply pipe 13B is provided an adjustment mechanism 15B for adjusting the amount (supply amount per unit time) of the cathode water 2B supplied to the mixing apparatus 14, which is produced by the ion water production apparatus 12. Moreover, part way along the fourth supply pipe 13D is provided an adjustment mechanism 15D for adjusting the amount (supply amount per unit time) of the extra pure water 2P supplied to the mixing apparatus 14, which is produced by the extra pure water production apparatus 11. The adjustment mechanisms 15A, 15B and 15D include for example valve mechanisms.

The mixing apparatus 14 mixes the anode water 2A, the cathode water 2B, and the extra pure water 2P which are respectively supplied via the first supply pipe 13A, the second supply pipe 13B and the fourth supply pipe 13D. The liquid 2 produced by the mixing apparatus 14 is supplied to the supply ports 8 via the third supply pipe 13C and the supply passage 8L which is formed in the nozzle member 6. The liquid 2 supplied to the supply ports 8 by supply pipe system 13 is supplied to the optical path space K by the supply ports 8.

In the present embodiment, the liquid which is produced by the mixing apparatus 14 and supplied to the supply ports 8 (the optical path space K) is appropriately called mixed water 2 (or liquid 2).

In the present embodiment, the respective pipes 13A, 13B, 13C, 13D and 13P of the supply pipe system 13 are formed from a material including for example polytetrofluroethelene (Teflon (registered trademark)). Since the polytetrofluroethelene is a material which is not readily eluted by impurities (eluate) in the liquid (water), that is, a material which does not readily contaminate the liquid (water), the liquid flowing in the supply pipe system 13 is supplied to the supply ports 8 without being contaminated.

Furthermore, in the supply passage 8L, there is provided a filter 16 for removing static electricity which becomes charged on the liquid 2. In the following description, the charged liquid is made electrically neutral, removal of the electricity (static electricity) charged on this liquid is appropriately called charge removal, and the filter 16 which removes the static electricity is appropriately called a charge removal filter 16.

The charge removal filter 16 is a formed from an electroconductive metal form, and is grounded (earthed) via an earth wire (not shown in the figure). The electroconductive metal form is made for example from porous copper, or aluminum, or the like. The charge removal filter 16 may be made from an electroconductive mesh member.

In FIG. 3, the supply passage 8L is simplified, however the supply passage 8L is multiply provided so as to respectively connect the plurality of supply ports 8 (8A to 8D), and charge removal filters 16 are respectively provided for these supply passages 8L. In the present embodiment, the interior of the nozzle member 6 is provided with a main passage for connecting to the bottom end portion of the third supply pipe 13C of the supply pipe system 13, and a plurality of branch passages provided so as to branch from the main passage towards the supply ports 8A to 8D. The charge removal filters 16 are provided for each of the plurality of branch passages.

Next is a description of the method of exposing the substrate P using the exposure apparatus EX having the above configuration.

The control apparatus 7 drives the immersion system 1 in order to immersion expose the substrate P. The extra pure water 2P produced by the extra pure water production apparatus 11 is supplied to the ion water production apparatus 12 via the connection pipe 13P. The ion water production apparatus 12 ionizes the extra pure water 2P, and respectively creates the anode water 2A and the cathode water 2B.

The anode water 2A and the cathode water 2B produced by the ion water production apparatus 12 are supplied to the mixing apparatus 14 via the first supply pipe 13A and the second supply pipe 13B. Furthermore, the extra pure water 2P produced by the extra pure water production apparatus 11 is supplied to the mixing apparatus 14 via the fourth supply pipe 13D.

Here the control apparatus 7 uses the adjustment mechanisms 15A, 15B, and 15D, so as to make the amount of extra pure water 2P supplied to the mixing apparatus 14 via the fourth supply pipe 13D, a greater amount than the ion water 2A and 2B supplied to the mixing apparatus 14 via the first and second supply pipes 13A and 13B. That is to say, in the present embodiment, to the extra pure water 2P supplied to the mixing apparatus 14, a small amount of ion water 2A and 2B is added. The mixing apparatus 14 mixes the anode water 2A, the cathode water 2B, and the extra pure water 2P respectively supplied via the first supply pipe 13A, the second supply pipe 13B, and the fourth supply pipe 13D, and produces mixed water 2.

The extra pure water 2P has a high electrical non conductivity, for example the resistivity thereof is approximately 18 MΩ·cm. Therefore, the extra pure water 2P is easily charged (readily takes on static electricity) by for example friction with the fourth supply pipe 13D, or cavitation generated in the orifice provided in the pipe, while flowing through the fourth supply pipe 13D. On the other hand, since the ion water 2A and 2B has electroconductivity, then even when this flows in the first and second supply pipes 13A and 13B, this is unlikely to be charged. Regarding the liquid supply system 10, even in the case where the extra pure water 2P which flows in the fourth supply pipe 13D is charged, this extra pure water 2P is mixed with the ion water 2A and 2B in the mixing apparatus 14, and hence the extra pure water 2P is electrically neutralized by the ion water 2A and 2B, so that the static electricity with which the extra pure water 2P is charged can be removed (uncharged).

The mixed water (liquid) 2 which is produced by the mixing apparatus 14 and from which the charge has been removed is supplied to the supply ports 8 via the third supply pipe 13C and a supply passage 8L formed in the nozzle member 6. The liquid 2 produced in the mixing apparatus 14 flows in the third supply pipe 13C and/or the supply passage 8L. The mixing apparatus 14 is provided in the vicinity of the supply ports 8 (nozzle member 6), and the liquid supply system 10 uses the mixing apparatus 14 to mix the ion water 2A and 2B, and the extra pure water 2P prior to supplying to the optical path space K. That is to say, the length of the passage between the mixing apparatus 14 and the supply ports 8 is short. Consequently, the liquid 2 after charge has been removed in the mixing apparatus 14 is kept from being recharged while flowing in the third supply pipe 13C and the supply passage 8L.

Furthermore, in the present embodiment, the charge removal filter 16 which functions as a charge removal device for removing the charge of the liquid 2, is provided part way along the supply passage 8L. The charge removal filter 16 including a foam metal or the like passes the liquid 2, and the static electricity charged on the liquid 2 is recovered by the charge removal filter 16, and discharged to earth by an earth wire. That is, removal of charge from the liquid 2 can be performed by the charge removal filter 16. Therefore, even if the liquid 2 flowing in the third supply pipe 13C and/or the supply passage 8L is temporarily charged, by using the charge removal filter 16, the charge can be removed from the liquid 2.

Moreover, by supplying the uncharged liquid 2 to the supply ports 8, uncharged liquid 2 is supplied from the supply ports 8 to the optical path space K. The optical path space K is filled by the liquid 2 which has not taken on static electricity. The control apparatus 7 irradiates the substrate P with the exposure light EL via the liquid 2 which has been filled into the optical path space K, to thereby immersion expose the substrate P.

The exposure apparatus EX of the present embodiment is a scanning type exposure apparatus (a so called scanning stepper) which exposes the pattern formed on the mask M onto the substrate P while the mask M and the substrate P are simultaneously moved in a predetermined scanning direction (for example the Y axis direction). The control apparatus 7 uses a laser interferometer 4L to measure the position information of the substrate P (the substrate stage 4), and moves the substrate P with respect to the exposure light EL, and sequentially exposes the plurality of shot regions provided on the substrate P. The control apparatus 7, on completion of exposure of one shot region, stepping moves the substrate P (substrate stage 4), and moves the next shot region to the exposure commencement position, and thereafter moves the substrate P by a step and scan method, to sequentially scan and expose the respective shot regions. In the exposure apparatus EX of the present embodiment, since the charge has been removed from the liquid 2 which is supplied to the supply ports 8, that is to say, the charge has been removed from the liquid 2 prior to the liquid 2 being supplied to the optical path space K, then liquid 2 which is not charged is supplied to the optical path space K. The exposure apparatus EX can thus expose the substrate P via the liquid 2 which is not charged.

As described above, by supplying the ionized ion water 2A and 2B to the supply ports 8, the situation where charged water 2 is filled into the optical path space K can be prevented. Consequently, the occurrence of the unfavorable situation such as where for example the pattern (circuit pattern) previously formed on the substrate P becomes damaged by discharge of static electricity, or the electrical apparatus arranged around the projection optical system PL and/or the substrate P malfunctions due to electrical noise generated at the time of discharge of static electricity, can be suppressed. Furthermore, if impurities of the surroundings of the optical path space K are attracted to the liquid 2 and/or the substrate P due to static electricity of the charged liquid 2, then due to these impurities the substrate P can no longer be favorably exposed. However, by supplying uncharged liquid 2, the occurrence of this unfavorable situation can also be suppressed. In this manner, by performing uncharging of the liquid 2, deterioration in the performance of a manufactured device, or deterioration in the performance of the exposure apparatus EX can be prevented, and a drop in yield at the time of manufacturing the devices can be suppressed.

Furthermore, in the present embodiment, since the configuration is such that the extra pure water 2P having electrical non conductivity is ionized, and manifests electroconductivity, then an additive for imparting conductivity to the extra pure water 2P (liquid 2) is not added. Consequently, the content of impurities of the liquid 2 supplied to the supply ports 8 (optical path space K) is very low, so that this does not cause a drop in light transmission of the liquid 2, an increase in temperature, or metal pollution, or the like. Hence liquid 2 for which the desired liquid properties are maintained, can be filled into the optical path space K, and the substrate P can be satisfactorily exposed.

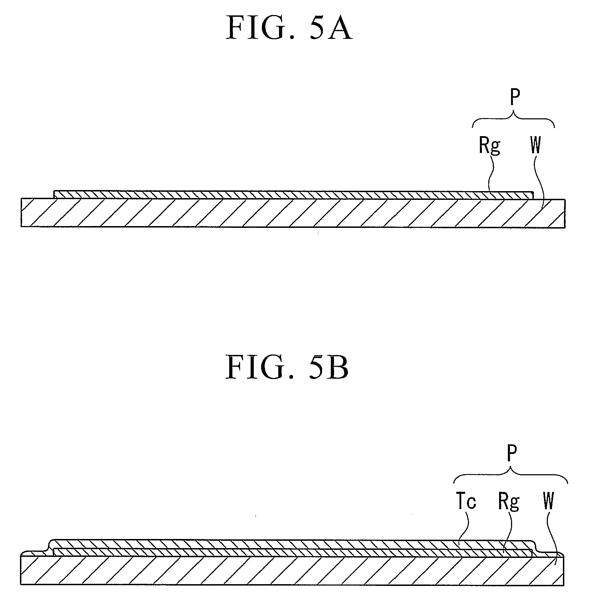

As a form of the substrate P exposed by the exposure light EL, there is the form shown in FIG. 5A and 5B. The substrate P shown in FIG. 5A includes a base substrate W of for example a semiconductor wafer, and a first film Rg including a sensitive material which covers the base substrate W. Furthermore, the substrate P shown in FIG. 5B includes a base substrate W of a semiconductor wafer or the like, a first film Rg which covers the base substrate W, and a second film Tc which covers the first film Rg. Here the second film Tc is called a top coat film, and for example has a function such as protecting the first film Rg and the base substrate W from the liquid 2. Moreover, in the substrate P shown in FIG. 5A, the first film Rg forms a liquid contact film for contact with the liquid 2, and in the substrate P shown in FIG. 5B, the second film Tc forms a liquid contact surface for contact with the liquid 2. Due to discharge from the liquid 2, the first film Rg and/or the second film Tc is damaged, so that there is the possibility of occurrence of an undesirable situation where the substrate P cannot be satisfactorily exposed. However, by supplying the uncharged liquid 2 onto the substrate P, the occurrence of such an undesirable situation can be prevented. In particular, in the immersion exposure, since an immersion region LR of a desired condition where the liquid 2 is favorably retained between the projection optical system PL and the substrate P, then in the case where the affinity (contact angle) between the liquid 2 and the liquid contact surface of the substrate P is optimized, there is the possibility that the first film Rg and/or the second film Tc which form the liquid contact surface of the substrate P, are damaged due to discharge of the liquid 2, and the contact angle of the liquid 2 and the substrate P changes, so that the immersion region LR cannot be favorably formed. In the present embodiment, since the charge is removed from the liquid 2 prior to supply to the optical path space K, damage to the substrate P including the first film Rg and the second film Tc is suppressed, and the immersion region LR can be favorably formed.

Furthermore, in the present embodiment, the liquid supply system 10 supplies both the anode water 2A and the cathode water 2B. Consequently, even if the extra pure water 2P supplied from the extra pure water production apparatus 11 to the mixing apparatus 14 by the fourth supply pipe 13D is charged positive or negative, then due to either one of the anode water 2A and the cathode water 2B, the extra pure water 2P can be uncharged. That is to say, even if it is not known whether or not the extra pure water 2P is charged either positive or negative, both of the anode water 2A and the cathode water 2B are supplied to the mixing apparatus 14, and in the mixing apparatus 14, the extra pure water 2P is mixed with the anode water 2A and the cathode water 2B, so that the extra pure water 2P can be uncharged by either one of the anode water 2A and the cathode water 2B.

Moreover, in the present embodiment, water (pure water) is used as the liquid. However in the case where a liquid other than water is used, a situation can arise where it is not known if the liquid is charged positive or negative by the material or the like of the pipe through which this liquid flows. In this case also, by mixing a non ionized liquid which is charged, and a positive ion liquid and a negative ion liquid which are produced by ionizing the non ionized liquid, the non ionic liquid can be uncharged by either one of the positive ion liquid and the negative ion liquid.

Furthermore, since the amount of ion water 2A and 2B for removing the static electricity charged on the extra pure water 2P need only be small, then as with the present embodiment, the amount of extra pure water 2P supplied to the mixing apparatus 14 becomes greater than the amount of ion water 2A and 2B, so that in the ion water production apparatus 12, it is not necessary to produce a large amount of ion water 2A and 2B. The control apparatus 7 uses the adjustment mechanisms 15A, 15B and 15D, and optimizes the respective feed rates of the ion water 2A and 2B, and the extra pure water 2P, to the mixing apparatus 14, so that the extra pure water 2P can be favorably uncharged.

Moreover, in the present embodiment, since the charge removal filter 16 is provided along the passage through which the liquid 2 flows, removal of charge of the liquid 2 which is supplied to the optical path space K via the supply ports 8 can be more reliably performed.

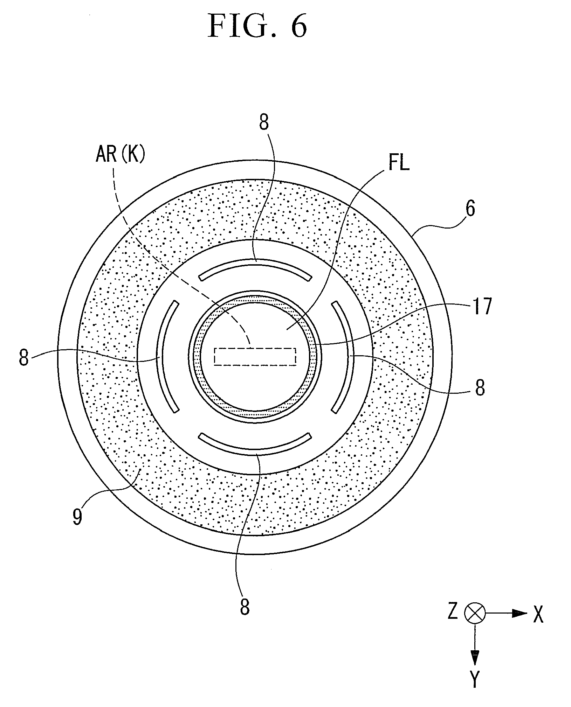

As shown in FIG. 6, an electrode member 17 for removing charge from the liquid 2 may be provided at a position contacting with the liquid 2 which is filled into the optical path space K, for example on the bottom surface or the like of the final optical element FL. The electrode member 17 shown in FIG. 6 is provided at a position on the bottom surface of the final optical element FL to contact with the liquid 2 which fills the optical path space K, and so as not to disturb the passage of the exposure light EL. In the example shown in FIG. 6, the electrode member 17 is provided in an annular shape so as to cover the peripheral region of the bottom surface of the final optical element FL. The electrode member 17 is a conductor formed for example by vapor deposition on the bottom surface of the final optical element FL. The electrode member 17 is earthed via a earth wire (not shown in the figure). The electrode member 17 can perform uncharging of the liquid 2 after this has been supplied to the optical path space K from the supply ports 8. Consequently, even if the liquid 2 after being supplied to the optical path space K via the supply ports 8 is temporarily charged, the removal of charge from the liquid 2 can be performed using the electrode member 17. The electrode member 17 may be provided instead of the charge removal filter 16. Alternatively, this can be used in combination with the charge removal filter 16. Hereunder, the electrode member 17 is called an electroconductive member.

In the abovementioned embodiment, the porous member 9T provided in the collection port 9 may also be constructed by a conductor. A porous member 9T including a conductor arranged in the collection port 9 is earthed via an earth wire. The porous member 9T arranged in the collection port 9 contacts with the liquid 2 filled in the optical path space K, and hence removal of charge from the liquid 2 after supply to the optical path space K can be performed. In this case, at least one of the charge removal filter 16 and the electrode member (electroconductive member) 17 may be combined with this.

In the abovementioned embodiment, the charge removal filter 16 is provided in the supply passage, however this charge removal filter 16 may be omitted. If the liquid 2 supplied to the supply ports 8 can be sufficiently uncharged by mixing (adding) the ion water 2A and 2B to the extra pure water 2P which is non ion water, then the charge removal filter 16 can be omitted. Similarly, the electrode member 17 can be omitted.

### <Second embodiment>

Next is a description of a second embodiment. Components the same as or similar to those of the abovementioned embodiment are denoted by the same reference symbols, and description thereof is simplified or omitted.

FIG. 7 shows a liquid supply system 10 according to the second embodiment. In FIG. 7, the liquid supply system 10 includes; a first supply pipe 13A which flows either one of anode water 2A and cathode water 2B produced by an ion water production apparatus 12, and a fourth supply pipe 13D which flows extra pure water 2P which has not been ionized. Furthermore, a mixing apparatus 14 is provided in the vicinity of a nozzle member 6 (supply ports 8) for mixing the anode water 2A or the cathode water 2B which flows in the first supply pipe 13A, with the extra pure water 2P which is flowed in the fourth supply pipe 13D. The liquid 2 produced by the mixing apparatus 14 is supplied to the supply ports 8 via a third supply pipe 13C and a supply passage 8L.

In the case where it is known before hand by for example experiment or simulation if the extra pure water 2P which flows in the fourth supply pipe 13D is charged either positively or negatively, the control apparatus 7 controls the ion water production apparatus 12, so as to supply ion water for removing the charge of the extra pure water 2P, to the mixing apparatus 14 via the first supply pipe 13A. That is to say, there is a case where it is known beforehand if the extra pure water 2P is charged positively or negatively by for example the material of the fourth supply pipe 13D which flows the extra pure water 2P. Therefore, if the charge can be removed from the charged extra pure water 2P by the anode water 2A, the control apparatus 7 supplies the anode water 2A from the ion water production apparatus 12 to the mixing apparatus 14 via the first supply pipe 13A. As a result, the liquid supply system 10, can remove the charge from the extra pure water 2P by the anode water 2A , in the mixing apparatus 14. On the other hand, if the charge can be removed from the extra pure water 2P which has been charged by flowing through the fourth supply pipe 13D, by means of cathode water 2B, the control apparatus 7 supplies the cathode water 2B from the ion water production apparatus 12 to the mixing apparatus 14 by the first supply pipe 13A. As a result, the liquid supply system 10 can remove the charge from the extra pure water 2P by the cathode water 2B, in the mixing apparatus 14. In this manner, the control apparatus 7 can select which of the anode water 2A and the cathode water 2B to supply to the mixing apparatus 14 corresponding to the charge state of the extra pure water 2P, and supply the selected water to the mixing apparatus 14.

Moreover, the liquid supply system 10 supplies the mixed water (liquid) 2 produced by the mixing apparatus 14 to the supply ports 8 via the third supply pipe 13C and the supply passage 8L, so that the liquid 2 with charge removed is supplied from the supply ports 8 to the optical path space K. The optical path space K is filled with liquid 2 which carries no static electricity.

In the present embodiment, the ion water production apparatus 12 is of a construction which can produce both the anode water 2A and the cathode water 2B. However, in the case where the charge condition of the extra pure water 2P which flows in the fourth supply pipe 13D is known beforehand, that is to say, it is known whether the extra pure water 2P which flows through the fourth supply pipe 13D is positively or negatively charged, the ion water production apparatus 12 can produce either one of the anode water 2A and the cathode water 2B.

Furthermore, in the present embodiment, even in the case where liquid other than water is used, in the case where it is known beforehand whether the liquid is positively or negatively charged by the material or the like of the pipe through which the liquid flows, then by mixing either one of a positive ion liquid and a negative ion liquid with the charged non ionized liquid, the non ion liquid can be uncharged.

### <Third embodiment>

Next is a description of a third embodiment. In the following description, components the same as or similar to those of the abovementioned embodiments are denoted by the same reference symbols, and description thereof is simplified or omitted. FIG. 8 shows a liquid supply system 10 according to the third embodiment. In FIG. 7, in a fourth supply pipe 13D through which the extra pure water 2P being the non ion water flows, a measuring device 18 is provided which can measure the charge state of the extra pure water 2P which flows in the fourth supply pipe 13D. The measuring device 18 can measure the charge amount of the extra pure water 2P which flows in the fourth supply pipe 13D. Furthermore, the measuring device 18 can measure if the extra pure water 2P which flows in the fourth supply pipe 13D is charged with a positive or a negative charge.

The control apparatus 7 controls the mixing operation in the mixing apparatus 14 based on the measurement results of the measuring device 18. For example, in the case where the control apparatus 7 based on the measurement results of the measuring device 18, judges that the charge amount of the extra pure water 2P which flows through the fourth supply pipe 13D is very slight (or the extra pure water 2P is not charged), it controls adjustment mechanisms 15A and 15B respectively provided in a first supply pipe 13A and a second supply pipe 13B, so that the amount of ion water 2A and 2B supplied to a mixing apparatus 14 via the first supply pipe 13A and the second supply pipe 13B is reduced. Alternatively, in the case where the control apparatus 7 based on the measurement results of the measuring device 18, judges that the charge amount of the extra pure water 2P which flows through the fourth supply pipe 13D is very slight (or the extra pure water 2P is not charged), it controls the adjustment mechanisms 15A and the 15B so that the supply of ion water 2A and 2B to the mixing apparatus 14 is stopped. On the other hand, in the case where the control apparatus 7 based on the measurement results of the measuring device 18, judges that the charge amount of the extra pure water 2P which flows through the fourth supply pipe 13D is great, it controls the adjustment mechanisms 15A and 15B so that the amount of ion water 2A and 2B supplied to the mixing apparatus 14 via the first supply pipe 13A and the second supply pipe 13B is increased. Furthermore, in the case where the control apparatus 7 judges that the extra pure water 2P can be uncharged by adding the anode water 2A to the extra pure water 2P, it controls the adjustment mechanisms 15A and 15B so as to supply the anode water 2A to the mixing apparatus 14. Similarly, in the case where the control apparatus 7 judges that the extra pure water 2P can be uncharged by adding the cathode water 2B to the extra pure water 2P, it controls the adjustment mechanisms 15A and 15B so that the cathode water 2B is supplied to the mixing apparatus 14. In the present embodiment, both the charge amount of the extra pure water 2P, and whether this is charged positively or negatively is measured. However the invention is not limited to this, and only one or the other need be measured.

### <Fourth embodiment>

Next is a description of a fourth embodiment. In the following description, components the same as or similar to those of the abovementioned embodiments are denoted by the same reference symbols, and description thereof is simplified or omitted. FIG. 9 shows a liquid supply system 10 according to the fourth embodiment. In FIG. 9, the liquid supply system 10 includes; a first supply pipe 13A which flows anode water 2A produced by an ion water production apparatus 12, and a second supply pipe 13B which flows cathode water 2B. A mixing apparatus 14 is provided in the vicinity of a nozzle member 6 (supply ports 8) for mixing the anode water 2A which flows in the first supply pipe 13A, and the cathode water 2B which flows in the second supply pipe 13B. The liquid 2 produced by the mixing apparatus 14 is supplied to the supply ports 8 via a third supply pipe 13C and a supply passage 8L. In the present embodiment, extra pure water 2P is not supplied to the mixing apparatus 14, and the liquid supply system 10 uses the mixing apparatus 14, to mix the anode water 2A and the cathode water 2B immediately before supplying to the optical path space K.

Since the anode water 2A and the cathode water 2B have electrical conductivity, then even if these flow through the first supply pipe 13A and the second supply pipe 13B, they are not easily charged. By mixing the anode water 2A and the cathode water 2B supplied to the mixing apparatus 14, these are electrically neutralized. Furthermore, by supplying the electrically neutralized liquid (mixed water) 2 to the supply port 8, the optical path space K is filled with liquid 2 which does not carry static electricity.

### <Fifth embodiment>

Next is a description of a fifth embodiment. In the following description, components the same as or similar to those of the abovementioned embodiments are denoted by the same reference symbols, and description thereof is simplified or omitted. In the above described embodiments, the ion water 2A and 2B and the extra pure water 2P supplied towards the optical path space K are supplied towards the supply ports 8 after being processed (mixed) by the mixing apparatus 14, and are supplied to the optical path space K via the supply ports 8. However the characteristic part of the present embodiment is that the liquid supply system 10 has a passage for supplying the ion water 2A and 2B, and the extra pure water 2P directly to the supply ports 8.

In FIG. 10A, the liquid supply system 10 includes a first passage 13A for supplying anode water 2A to the supply ports 8 of the nozzle member 6, a second passage 13B for supplying cathode water 2B, and a fourth passage 13D for supplying extra pure water 2P. By means of such a construction, each of the anode water 2A, the cathode water 2B, and the extra pure water 2P supplied to the supply ports 8 are mixed in the vicinity of the supply ports 8, and then supplied to the optical path space K. As a result, liquid 2 which does not carry static electricity is filled in the optical path space K.

In FIG. 10B, the liquid supply system 10 uses the first passage 13A to supply either one of the anode water 2A and the cathode water 2B to the supply ports 8 of the nozzle member 6, and uses the fourth passage 13D to supply the extra pure water 2P. As a result, the anode water 2A (and the cathode water 2B) and the extra pure water 2P supplied to the supply ports 8 are mixed in the vicinity of the supply ports 8 and then supplied to the optical path space K. As a result, liquid 2 which does not carry static electricity is filled in the optical path space K.

In FIG. 10C the liquid supply system 10 uses the first passage 13A to supply the anode water 2A to the supply ports 8 of the nozzle member 6, and uses the second passage 13B to supply the cathode water 2B. As a result, the anode water 2A and the cathode water 2B supplied to the supply ports 8 are mixed in the vicinity of the supply ports 8, and then supplied to the optical path space K. As a result, liquid 2 which does not carry static electricity is filled in the optical path space K. In the present embodiment, since the liquid (mixed water) 2 filled in the optical path space K does not have conductivity, then even if friction occurs between the liquid 2 and another member when the substrate stage 4 is driven, the liquid 2 is not charged.

### <Sixth embodiment>

Next is a description of a sixth embodiment. In the following description, components the same as or similar to those of the abovementioned embodiments are denoted by the same reference symbols, and description thereof is simplified or omitted. In FIG. 11, a liquid supply system 10 includes a first supply port 8A (8C) for supplying ionized ion water 2A and 2B to an optical path space K of exposure light EL, and a second supply port 8B (8D) for supplying extra pure water 2P which has not been ionized to the optical path space K of the exposure light EL. As described with reference to FIG. 2 and such, a nozzle member 6 of this embodiment has a plurality of supply ports 8A to 8D, and the ion water 2A and 2B can be supplied to the optical path space K via the supply port of at least one of the plurality of supply ports 8A to 8D, and the extra pure water 2P can be supplied the optical path space K via the other of the supply ports. In the following description, for simplicity of explanation, the anode water 2A of the anode waters 2A and 2B is supplied from the supply port 8A, and the extra pure water 2P is supplied from the supply port 8B.

The supply port 8A is connected to an ion water production apparatus 12 via a supply passage 8L and a first supply pipe 13A, and the supply port 8B is connected to the extra pure water production apparatus 11 via a supply passage 8L and a fourth supply pipe 13D. A control apparatus 7, in order to fill the optical path space K with the liquid 2, respectively supplies anode water 2A and the extra pure water 2P to the optical path space K via the respective first supply port 8A and the second supply port 8b. The anode water 2A and the extra pure water 2P supplied to the optical path space K are mixed in the optical path space K. As a result, even if the extra pure water 2P is charged, the charge can be removed by the anode water 2A, and the optical path space K can be filled with liquid 2 which does not carry static electricity.

In the present embodiment, anode water 2A is supplied as ion water and from the supply port 8A, however cathode water 2B can be supplied. Furthermore, from each of the mutually different supply ports, anode water 2A and cathode water 2B can be respectively supplied. For example, the anode water 2A can be supplied from the supply port 8A, and the cathode water 2B can be supplied from the supply port 8C, and the extra pure water 2P can be supplied from the supply ports 8B and 8D. Furthermore, either one of the anode water 2A and the cathode water 2B can be supplied corresponding to the charge state of the extra pure water 2P, and the supply amount of the anode water 2A and the cathode water 2B can be appropriately adjusted.

Moreover, while not supplying the extra pure water 2P, the anode water 2A may be supplied via the first supply port 8A (8C) to the optical path space K of the exposure light EL, and the cathode water 2B may be supplied via the second supply port 8B (8D). The anode water 2A and the cathode water 2B supplied to the optical path space K are mixed in the optical path space K. As a result, the optical path space K can be filled with liquid 2 which does not carry static electricity.

### <Seventh embodiment>

Next is a description of a seventh embodiment. In the following description, components the same as or similar to those of the abovementioned embodiments are denoted by the same reference symbols, and description thereof is simplified or omitted. In this embodiment, the description is for an example where the member which contacts with the liquid 2 for filling the optical path space K of the exposure light EL is cleaned with ion water. Electrolytic ion water can be used as the cleaning liquid. The anode water has an action for removing organisms, a fungicidal action for eliminating live bacteria such as bacterium, or an action for removing particles. The cathode water has an action for removing particles, and/or an action for preventing attachment of particles. By using these ion waters 2A and 2B, the members such as the nozzle member 6 and the final optical element FL, which contact with the liquid 2 for filling the optical path space K, can be effectively cleaned.

Furthermore, in the case where pure water is used as the liquid 2 filled in the optical path space K, if this pure water is left for a long time in a condition remaining in the supply pipe system 13, the internal passage of the nozzle member 6 (the supply passage, the recovery passage), the recovery pipe system 23, and the like, or is left for a long time in a condition attached to the liquid contact surface (the bottom surface 6A or the like) of the nozzle member 6, or the liquid contact surface of the final optical element FL (the bottom surface or the like), there is the high possibility of generation of contaminants such as bacteria (live bacteria). If contaminants such as bacteria occur in the passage in which the liquid 2 flows, then even if clean liquid is sent from the extra pure water production apparatus 11 or the ion water production apparatus 12, the liquid is contaminated by the contaminants while flowing in the passage, so that contaminated liquid 2 is supplied to the optical path space K. Furthermore, in the case where contaminants are attached to the final optical element FL, illumination of the exposure light EL which illuminates the substrate P is reduced, and undesirable illumination irregularity occurs. In this manner, there is the likelihood of the occurrence of undesirable deterioration of the performance of the exposure apparatus EX which includes the projection optical system PL, due the occurrence of contaminants such as bacteria.

Therefore, by flowing the anode water 2A having a fungicidal action, through the passages of the supply pipe system 13, the internal passage of the nozzle member 6, the recovery piping system 23, and the like, these passages, the bottom surface of the nozzle member 6, and the final optical element FL can be cleaned, and bacteria and the like can be removed (eliminated).

FIG. 12 shows a condition where a cleaning process is performed using anode water 2A. The cleaning process is performed for example at the time of maintenance of the exposure apparatus EX, when the operation of the exposure apparatus EX is stopped for a predetermined period. At the time of the cleaning process, a dummy substrate DP is held in the substrate holder 4H of the substrate stage 4. The dummy substrate DP has approximately the same shape as the substrate P for fabricating a device, and can be held by the substrate holder 4H. The dummy substrate DP has a surface which does not generate pollutants due to the anode water 2A. When the cleaning process is performed, the final optical element FL of the projection optical system PL, and the dummy substrate DP held in the substrate stage 4 face each other. In this condition, the exposure apparatus EX fills between the projection optical system PL and the dummy substrate DP with the anode water 2A using the immersion system 1, and forms an immersion region LR of the anode water 2A on the dummy substrate DP. The immersion system 1 in order to form the immersion region LR, concurrently performs the supply operation and the recovery operation of the anode water 2A with respect to the space (optical path space) K between the final optical element FL and the nozzle member 6, and the dummy substrate DP. As result, the immersion system 1 can flow the anode water 2A in the passages of the supply pipe system 13, the internal passage of the nozzle member 6, the recovery pipe system 23, and the like, and these passages can be cleaned with the anode water 2A. Furthermore, by forming the immersion region LR of the anode water 2A, the bottom surface of the nozzle member 6 (the liquid contact surface), the bottom surface (the liquid contact surface) of the final optical element FL, and the like are also cleaned with the anode water 2A.

When performing the cleaning process, the immersion system 1 carries out concurrently at a predetermined time the supply operation and the recovery operation of the anode water 2A with respect to the optical path space K. The immersion system 1 may retain the anode water 2A between the final optical element FL and the nozzle member 6, and the dummy substrate DP, and then stop the supply operation and the recovery operation of the anode water 2A.

In the case where after completion of the cleaning process using the anode water 2A, the exposure process of the substrate P for fabricating the device is restarted, the immersion system 1, as described for the aforementioned first through sixth embodiments, appropriately supplies the ion water 2A and 2B and the extra pure water 2P to the optical path space K. After the cleaning process, even if the anode water 2A remains in the supply pipe system 13 or in the supply passage of the nozzle member 6, the anode water 2A is mixed with the supplied ion water 2A and 2B and the extra pure water 2P, and supplied the optical path space K, after which it is recovered via the collection port 22.

As described above, the cleaning process can be performed using ion water (anode water). Furthermore, in the present embodiment, since the extra pure water 2P is subjected to the cleaning process with the ionized ion water (anode water), then after the cleaning process, it is possible to move to the exposure process in a short time. That is to say, in the case where in order to clean the passage of the supply pipe system 13 or the like, a cleaning functional liquid different to the liquid (water) filled in the optical path space K when performing immersion exposure is used, then after the cleaning process using the functional liquid, and before moving to the exposure process, a process for rinsing out the functional liquid (rinse wash) which remains in the passage is necessary. In the present embodiment, rinse cleaning is unnecessary, or even if rinse cleaning is performed, this is completed in a short time. Therefore the availability factor of the exposure apparatus EX can be improved.

To the liquid for cleaning (anode water) a predetermined substance (chemical) for promoting the cleaning action (fungicidal action) may be appropriately added.

In the present embodiment, the dummy substrate DP is held by the substrate holder 4H, and the space between the projection optical system PL and the dummy substrate DP is filled with the anode water 2A, to form the immersion region LR. However, for example part of the upper surface 4F of the substrate stage 4, and an object separate to the substrate stage 4 and the dummy substrate DP may be arranged below the projection optical system PL, and the immersion region LR of the anode water 2A may be formed on the upper surface 4F of the substrate stage 4 and/or on the object. In this case, the upper surface 4F of the substrate stage 4 and/or the object can be cleaned with the anode water 2A. The separate object includes for example a measuring stage which is moveable independently to the substrate stage 4, and the surface of the measuring stage (including the measuring members such as the reference mark and the sensor) and the like can also be cleaned.

When cleaning using the anode water 2A, an agitating device such as an ultrasonic transducer may be attached for example to the supply pipe system 13, the recovery piping system 23, or the nozzle member 6, and the anode water 2A flowed while agitating (ultrasonic agitating) these members.

In the present embodiment, cleaning is performed by the anode water 2A, however cleaning may be performed using the cathode water 2B. As mentioned above, the cathode water 2B also has a cleaning action such as particle removal.

Furthermore, cleaning may be performed using both of the anode water 2A and the cathode water 2B. Moreover, in the present embodiment, ion water (at least one of the anode water 2A and the cathode water 2B) is supplied from the supply ports 8 of the nozzle member 6, to perform cleaning of the member which contacts with the liquid 2. However, the invention is not limited to this, and for example a supply port may be provided in an object (for example the aforementioned measuring stage) arranged facing the final optical element FL of the projection optical system PL and/or the nozzle member 6, and cleaning performed on the nozzle member 6 and the like with ion water from this supply port. In particular, in the case where an electric charge on the liquid 2 at the optical path space K is not a problem, then for example the ion water produced by the ion water production apparatus 12 can be guided to the object rather than the nozzle member 6. Furthermore, in the present embodiment, the abovementioned cleaning process is performed at the time of maintenance or the like after the operation of the exposure apparatus EX has been stopped for a predetermined period. However, the invention is not limited to this, and for example the aforementioned cleaning process may be performed even during operation of the exposure apparatus EX.

### <Eighth embodiment>

Next is a description of an eighth embodiment. In the following description, components the same as or similar to those of the abovementioned embodiments are denoted by the same reference symbols, and description thereof is simplified or omitted. In the abovementioned respective embodiments, the description was for where the ion water 2A and 2B is supplied to the optical path space K of the exposure light EL between the final optical element FL of the projection optical system PL which is closest to the image surface of the projection optical system PL, and the substrate P (or an object such as the dummy substrate DP). However for example as disclosed in PCT International Patent Publication No. WO 2004/019128, the optical path space on the object surface side (the mask M side) of the final optical element FL can also be filled with liquid.

In FIG. 13, an exposure apparatus EX is furnished with an immersion system 1' for supplying ion water 2A and 2B to between a final optical element FL, and an optical element FL2 next closest to an image surface of a projection optical system PL, after the final optical element FL. In the following description, the optical element FL2 next closest to the image surface of the projection optical system PL, after the final optical element FL is appropriately called a boundary optical element FL2.

The immersion system 1' includes a supply port 8' for supplying liquid 2 to an optical path space K2 between the final optical element FL and the boundary optical element FL2, and a collection port 9' for recovering the liquid 2. The immersion system 1' has substantially the same construction as the aforementioned immersion system 1 described for the first embodiment, and is provided with a mixing apparatus 14 for mixing extra pure water 2P produced by an extra pure water production apparatus 11, and the ion water 2A and 2B produced by an ion water production apparatus 12. The mixed water (liquid) 2 produced by the mixing apparatus 14 is supplied to the optical path space K2. As a result, uncharged liquid 2 is supplied from the supply port 8' to the optical path space K2. The optical path space K2 is filled with liquid 2 which does not carry static electricity. Consequently, the occurrence of the unfavorable situation such as where the electrical apparatus arranged around the projection optical system PL malfunctions due to electrical noise generated at the time of discharge of static electricity, and the optical elements FL and FL2 are damaged by discharge of static electricity, can be suppressed.

Of course, similarly to the abovementioned respective embodiments, the extra pure water 2P, and either one of the anode water 2A and the cathode water 2B, may be supplied to the optical path space K2. Moreover, the mixing operation in the mixing apparatus 14 may be controlled corresponding to the charge state of the extra pure water 2P. Furthermore, the anode water 2A and the cathode water 2B may be supplied without supplying the extra pure water 2P. Moreover, the mixing apparatus 14 may be not provided, and the ion water 2A and 2B, and the extra pure water 2P may be appropriately supplied directly to the supply ports 8'. Furthermore each of the ion water 2A and 2B and the extra pure water 2P may be supplied to the optical path space K2 by separate supply ports. Moreover each of the anode water 2A and the cathode water 2B may be supplied to the optical path space K2 via separate supply ports.

Moreover, for example at the time of maintenance of the exposure apparatus EX, the immersion system 1' may be used to supply ion water (anode water) to the optical path space K2. As a result contamination of the boundary optical element FL2 and the final optical element FL and the like by bacteria or the like can be prevented. When the anode water 2A is supplied to the optical path space K2 to clean the final optical element FL, the boundary optical element FL2 and the inner wall of the lens barrel PK, the immersion system 1'may carry out concurrently at a predetermined time the supply operation and the recovery operation of the anode water 2A with respect to the optical path space K2, and after filling the optical path space K2 with the anode water 2A, stop the supply operation and the recovery operation of the anode water 2A.

Similarly, the cleaning process may be performed using cathode water 2B. In the present embodiment, the immersion system 1' is provided separate to the immersion system 1. However at least one part of the immersion system 1' may be used in conjunction with the immersion system 1. Furthermore, similarly to the abovementioned first embodiment, instead of supplying the ion water, or in combination with this, an electrode member (an electroconductive member for preventing charging of the liquid 2) may be provided for removing the charge of the liquid 2 at a predetermined position of the optical path space K2, for example on at least one of the bottom surface (the emission surface) of the boundary optical element FL2, and the upper surface (incident surface) of the final optical element FL. Furthermore, a charge removal filter may be provided in the supply passage of the liquid 2.

In the abovementioned first through eighth embodiments, the exposure apparatus EX is constructed with the ion water production apparatus 12. However, ion water produced by an ion water production apparatus separate to the exposure apparatus EX, may be supplied to the optical path space K (K2). Similarly, pure water produced by a pure water generation apparatus separate to the exposure apparatus EX may be used. In short, the exposure apparatus EX need only be provided with at least one of a pure water generation apparatus and an ion water production apparatus.

### <Ninth embodiment>

Next is a description of a ninth embodiment. In the following description, components the same as or similar to those of the abovementioned embodiments are denoted by the same reference symbols, and description thereof is simplified or omitted. In the present embodiment, the description is given of an example where the liquid 2 for filling the optical path space K of the exposure light EL is degassed.

Furthermore, the exposure apparatus EX of the present embodiment is furnished with an antistatic device for preventing charging of the liquid 2 in order to suppress defective exposure attributable to bubbles in the liquid 2. As described before, in the present embodiment a charge removal device (charge removal filter) for removing electricity charged on the liquid 2 is provided as the antistatic device, and by removing electricity charged on the liquid 2, the charge of the liquid 2 is removed or effectively suppressed.

As shown in FIG. 14, an immersion supply system 10 includes a liquid supply apparatus 111 for supplying liquid 2 to supply ports 8 via a supply pipe 113. In the interior of the nozzle member 6 is formed an internal passage (supply passage) for connecting between the supply ports 8 and the supply pipe 113. The liquid supply apparatus 111 can supply clean and temperature adjusted liquid 2 to the supply ports 8 via a supply passages of the supply pipe 113 and the nozzle member 6.

A liquid recovery system 20 includes a liquid recovery apparatus 121 for recovering liquid 2 via collection ports 9 of the nozzle member 6, and a recovery pipe 123. In the interior of the nozzle member 6 is formed an internal passage (recovery passage) for connecting between the collection ports 9 and the recovery pipe 123. A liquid recovery apparatus 121 which includes a vacuum system (suction apparatus) such as a vacuum pump can recover liquid 2 from the collection ports 9 via the recovery passage of the nozzle member 6, and the recovery pipe 123.

The nozzle member 6 is formed in an annular shape so as to surround the final optical element FL of the projection optical system PL. The supply ports 8 are respectively provided at a plurality of predetermined positions in the nozzle member 6 so as to surround the final optical element FL (the optical path space K) of the projection optical system PL. The collection ports 9 are provided in the nozzle member 6 further to the outside than the supply ports 8 with respect to the final optical element FL, and are provided in an annular shape so as to surround the final optical element FL and the supply ports 8.

In the present embodiment, in the collection ports 9 is arranged a mesh member made for example from titanium, or a porous member 9T including a porous body or the like made from ceramics.

FIG. 15 is a schematic block diagram showing the liquid supply apparatus 111. The liquid supply apparatus 111 includes; an extra pure water production apparatus 115 for producing pure water, a degassifier 116 for reducing the gas component in the supply liquid 2, and a temperature regulator 118 for adjusting the temperature of the supply liquid 2, and is capable of supplying pure temperature adjusted liquid 2.

The extra pure water production apparatus 115 purifies water to produce extra pure water. The extra pure water produced by the extra pure water production apparatus 115 is degassed by the degassifier 116. The degassifier 116 degasses the liquid 2 (extra pure water), and reduces the dissolved gas concentration in the liquid 2 (the dissolved oxygen concentration, the dissolved nitrogen concentration). The temperature regulator 118 performs temperature control of the liquid 2 supplied to the optical path space K. After performing temperature adjustment of the liquid 2, the temperature adjusted liquid 2 is sent to the supply pipe 113. The temperature regulator 118 adjusts the temperature of the supply liquid 2 to be substantially the same as the temperature inside a chamber (not shown in the figure) which accommodates for example the exposure apparatus.

An element which constitutes at least one part of the liquid supply system 10, for example the extra pure water production apparatus or the like, may be substituted by equipment of the factory or the like where the exposure apparatus EX is installed. Similarly, equipment constituting at least one part of the liquid recovery system 20 (refer to FIG. 14), for example the vacuum system or the like, may be substituted by equipment of the factory or the like where the exposure apparatus EX is installed. Furthermore the liquid supply apparatus 111 may includes a filter system for removing foreign materials (particles) in the liquid 2.

The supply pipe 113 is connected to the supply ports 8 via an internal passage 8L formed inside the nozzle member 6. In the present embodiment, a supply pipe 113 is formed from an insulating material including a fluoroplastic such as for example PTFE (polytetrafluroethelene), PFA (tetrafluoroethylene-perfluoroalkoxy ethylene copolymer) or the like. Since these materials are materials which are not readily eluted by impurities (eluates) in the liquid (water) 2, that is, materials which do not readily contaminate the liquid (water), the liquid 2 flowing in the supply pipe 113 is supplied to the supply ports 8 without being contaminated.

Furthermore, a filter 114 which functions as a charge removal device for removing static electricity charged on the liquid 2, is provided at a position which is contacted with the liquid 2 supplied to the optical path space K. In the present embodiment, the filter 114 is provided in the supply passage 8L, and can contact with the liquid 2 supplied to the optical path space K. In the following description, the charged liquid is made electrically neutral, removal of electricity (static electricity) charged on this liquid is appropriately called charge removal, and the filter 114 which removes the static electricity is appropriately called a charge removal filter 114.

The charge removal filter 114 is a conducting member having conductivity, and is earthed (grounded) via an earth wire (not shown in the figure). In the present embodiment, the charge removal filter 114 includes an electroconductive metal form. The electroconductive metal form is made for example from porous copper or aluminum, or the like. The charge removal filter 114 may be made from an electroconductive mesh member. By making the charge removal filter 114 from a metal form or a mesh member, the liquid 2 supplied from the liquid supply apparatus 111 towards the supply ports 8 can pass through the charge removal filter 114, and the liquid 2 with charge removed is supplied to the supply ports 8.

FIG. 16 is a schematic block diagram showing an example of the degasifier 116. The degasifier 116 includes a housing 171, and a cylindrical hollow fiber bundle 172 accommodated in the interior of the housing 171. A predetermined space 173 is provided between an inner wall of the housing 171 and the hollow fiber bundle 172. The hollow fiber bundle 172 includes a plurality of straw shape hollow fiber membranes 174 which are bundled together in parallel. The hollow fiber membranes 174 are made from an element with high hydrophobicity, and superior permeability (for example a poly-4-methyl pentene 1). Vacuum cap members 175a and 175b are secured to opposite ends of the housing 171. The vacuum cap members 175a and 175b form sealed spaces 176a and 176b on the opposite end outsides of the housing 171. Vent ports 177a and 177b which are connected to a vacuum pump (not shown in the figure) are provided in the vacuum cap members 175a and 175b. Furthermore, sealing members 178a and 178b are provided on the opposite ends of the housing 171. The vent ports 171a and 171b hold the hollow fiber bundle 172 so that only the opposite ends of the hollow fiber bundle 172 are communicated with the sealed spaces 176a and 176b. The vacuum pump connected to the vent ports 177a and 177b is capable of reducing the pressure on the inside of the respective hollow fiber membranes 174. A pipe 179 connected to an extra pure water production apparatus 115 is arranged on the inside of the hollow fiber bundle 172. A plurality of liquid supply holes 180 are provided in the pipe 179, and liquid 2 is supplied from the liquid supply holes 180 to a space 181 which is surrounded by the sealing members 178a and 178b, and the hollow fiber bundle 172. When the liquid 2 is supplied from the liquid supply holes 180 to the space 181, the liquid 2 flows towards the outside so as to traverse the layer of the hollow fiber membranes 174 bundled in parallel, and comes into contact with the outer surface of the hollow fibre membranes 174. As described above, each of the hollow fiber membranes 174 are made from a member with high hydrophobicity and superior permeability, and hence the liquid 2 does not flow into the inside of the hollow fiber membranes 174, but moves between the respective hollow fiber membranes 174 to the space 173 on the outside of the hollow fiber bundle 172. On the other hand, gas (molecules) dissolved in the liquid 2 move (are absorbed) to the inside of the respective hollow fiber membranes 174 because the inside of the hollow fiber membranes 174 is at a reduced pressure (approximately 20 Torr). The gas component removed (degassed) from the liquid 2 while traversing the layer of the hollow fiber membranes 174 is discharged from the vent ports 177a and 177b from opposite sides of the hollow fiber bundle 172 as shown by the arrows 183, via the sealed spaces 176a and 176b. Furthermore, the liquid 2 which has been subjected to degassing, is supplied from a liquid outlet 182 provided in the housing 171 to the supply pipe 113 (the optical path space K). In the present embodiment, the liquid supply apparatus 111 uses the degassifier 116, and the dissolved gas concentration of the liquid 2 supplied to the optical path space K is for example less than 5 ppm.

Next is a description of a method of exposing a substrate P using an exposure apparatus EX having the above mentioned structure (refer to FIG. 14). The control apparatus 7 drives the immersion system 1 in order to immersion expose the substrate P. The extra pure water (liquid 2) produced by the extra pure water production apparatus 115 is supplied to the degassifier 116. The degassifier 116 degasses the liquid 2. The liquid 2 degassed by the degassifier 116 passes through the temperature regulator 118 and is then supplied to the supply passage 8L in the nozzle member 6 via the supply pipe 113. The liquid 2 supplied to the supply passage 8L is supplied from the supply ports 8 to the optical path space K via the charge removal filter 114. The control apparatus 7 immersion exposes the substrate P by shining exposure light EL onto the substrate P via the liquid 2 which is filled in the optical path space K of the exposure light EL.

The exposure apparatus EX of this embodiment uses a charge removal filter 114 in order to suppress exposure defects attributable to bubbles in the liquid 2, and prevents charging of the liquid 2. The extra pure water has a high electrical non conductivity, for example the resistivity thereof is approximately 18 MΩ·cm. Therefore, the extra pure water is easily charged (readily takes on static electricity) by for example friction with the supply pipe 113, or cavitation generated in the orifice provided in the pipe, while flowing through the supply pipe 113. If the liquid 2 becomes charged, there is the possibility that it is difficult to reduce or eliminate the bubbles generated in the liquid 2.

The bubbles generated in the liquid 2 are self pressurized by the effect of surface tension, so that there is a high possibility of being rapidly dissolved in the liquid 2. In particular minute bubbles (hereunder called micro bubbles) of approximately 1 to 50 µm diameter, and super-minute bubbles (hereunder called nano bubbles) of 1 µm or less diameter which are generated in the process of reducing the micro bubbles are physically extremely unstable, and even if generated in the liquid 2, there is a high possibility of them being immediately decreased or eliminated.

Incidentally, in the case where the liquid 2 is charged, the amount of bubbles generated in the liquid 2 are not readily reduced or eliminated, so that they are very likely to remain in the liquid 2. In the case where the liquid 2 is charged, as shown in the schematic diagram of FIG. 17, a charge is arranged around the nano bubbles generated in the liquid 2, so that there is a high possibility that the nano bubbles are charged. If so, it is considered that an electrostatic repulsion force occurs, so that the further reduction of the nano bubbles is disturbed, making it is difficult reduce or eliminate the nano bubbles. In this manner, if the nano bubbles are charged accompanying charging of the liquid 2, there is a high possibility that it is difficult to reduce or eliminate the charged nano bubbles. Furthermore, also in the case where not just the nano bubbles but also the micro bubbles or bubbles larger than the micro bubbles are generated in the liquid 2, in the case where the liquid 2 is charged, there is a high possibility that it is difficult to reduce or eliminate the bubbles generated in the liquid 2. Since the bubbles including the nano bubbles and micro bubbles act as foreign materials, in the case where these bubbles exist in the liquid 2 which fills the optical path space K, or are attached on the substrate P, they cause the occurrence of defects and the like of the pattern produced on the substrate P, and defective exposure.

In FIG. 17, the bubbles are negatively charged, however they may also be positively charged.

In the present embodiment, by performing charge removal on the liquid 2 supplied to the optical path space K, using the charge removal filter 114, the charge of the liquid 2 filled in the optical path space K is prevented or effectively suppressed. In the above manner, since the nano bubbles are physically extremely unstable, in the case where the liquid 2 is not charged, the possibility of the nano bubbles being immediately reduced or eliminated is high. Consequently, by preventing charging of the liquid 2, then even if nano bubbles are generated in the liquid 2, the charging of these nano bubbles is suppressed, and the nano bubbles can be immediately reduced or eliminated. Consequently, the occurrence of defective exposure attributable to the presence of nano bubbles in the liquid 2 can be suppressed. Furthermore, by preventing no only charging of the nano bubbles but also charging of the liquid 2, the bubbles including the micro bubbles which are larger than the nano bubbles generated in the liquid 2 can be immediately reduced or eliminated.

As described with reference to FIG. 15, in the present embodiment, the charge removal filter 114 is provided in the supply passage 8L. When the liquid 2 passes through the charge removal filter 114 formed from for example a metal form, the static electricity charged on the liquid 2 is collected by the charge removal filter 114, and discharged to the ground by the earth wire. Therefore, even if the liquid 2 flowing in the supply pipe 113 and/or the supply passage 8L is temporarily charged, the charge removal filter 114 can perform discharging of the liquid 2. Consequently, the immersion system 1 can fill the optical path space K with the liquid 2 for which charging has been prevented or effectively suppressed, and the situation where bubbles remain in the liquid 2 can be suppressed.

Furthermore, in the present embodiment, the liquid supply apparatus 111 has the degassifier 116, and the immersion system 1 supplies degassed liquid 2 to the optical path space K of the exposure light EL. The degassed liquid 2 can dissolve and thus reduce or eliminate the bubbles. Consequently, the immersion system 1 supplies degassed liquid 2 in a condition where the charge of the liquid 2 is prevented or effectively suppressed, so that even in the case where bubbles are generated in the liquid 2, these bubbles are dissolved in the degassed liquid 2, and can be immediately reduced or eliminated.

As described above, in the case where the liquid 2 is charged, there is a high possibility that the bubbles generated in the liquid 2 are difficult to reduce or eliminate. However by preventing charging of the liquid 2, even in the case where bubbles are generated in the liquid 2, the charging of these bubbles can be suppressed. Consequently, the situation where bubbles remain in the liquid 2 can be suppressed, and the occurrence of defective exposure such as defects in the pattern attributable to the bubbles can be suppressed, and the substrate P can be favorably exposed.

Furthermore, in the present embodiment, since the immersion system 1 supplies degassed liquid 2 to the optical path space K of the exposure light EL, even if the bubbles are charged, charging of the bubbles is suppressed. Therefore bubbles which are generated are dissolved in the degassed liquid 2 and can be immediately reduced or eliminated. Consequently, by preventing charging of the liquid 2 by the charge removal filter 114, the situation where bubbles remain in the degassed liquid 2 can be effectively suppressed.

Moreover, by using the degassifier 116, and reducing the dissolved gas concentration in the liquid 2, in particular the dissolved oxygen concentration, a drop in the transmissivity of the liquid 2 with respect to the exposure light EL can be suppressed. Since there is the possibility that the oxygen absorbs the exposure light EL, so that the quantity of exposure light EL is reduced, if the dissolved oxygen concentration in the liquid 2 is high, it is likely that the transmissivity of the liquid 2 with respect to the exposure light EL is reduced. In the present embodiment, by using the degassifier 116 to reduce the dissolved gas concentration (the dissolved oxygen concentration), the drop in the transmissivity of the liquid 2 with respect to the exposure light EL can be suppressed.

Furthermore, in the present embodiment, the charge removal filter 114 provided in the supply passage 8L is used to remove charge on the liquid 2 prior to supply from the supply ports 8 of the immersion system 1 to the optical path space K of the exposure light EL, and to perform the process for preventing charging of the liquid 2 prior to supply to the optical path space K. Consequently, the immersion system 1 can fill the optical path space K with liquid 2 for which charging has been prevented or effectively suppressed.

### <Tenth embodiment>

Next is a description of a tenth embodiment. In the following description, components the same as or similar to those of the abovementioned embodiments are denoted by the same reference symbols, and description thereof is simplified or omitted.

As shown in FIG. 18, a conducting member 119 for preventing charging of the liquid 2, may be provided at a position, for example on the bottom surface of the final optical element FL, which contacts with the liquid 2 filled in the optical path space K. The conducting member 119 shown in FIG. 18 is provided at a position on the bottom surface of the final optical element FL, where it does not obstruct passage of the exposure light EL, and which contacts with the liquid 2 filled in the optical path space K. The conducting member 119 is formed for example in an annular shape so as to cover a peripheral region on the bottom surface of the final optical element FL. The conducting member 119 is for example a conductor formed by depositing on a bottom surface of the final optical element FL. The conducting member 119 is grounded (earth) via an earth wire (not shown in the figure). The conducting member 119 prevents charging of the liquid 2 after supply to the optical path space K by the supply port 8. Even if the liquid 2 is temporarily charged after being supplied to the optical path space K via the supply ports 8, the conducting member 119 can perform charge removal on the liquid 2, and hence charging of the liquid 2 filled in the optical path space K can be prevented or effectively suppressed. The conducting member 119 may be provided instead of the charge removal filter 114, or may be used in combination with the charge removal filter 114.

### <Eleventh embodiment>

Next is a description of an eleventh embodiment with reference to FIG. 19. In the following description, components the same as or similar to those of the abovementioned embodiments are denoted by the same reference symbols, and description thereof is simplified or omitted. The characteristic part of the present embodiment is that charging of the liquid 2 is prevented by mixing the liquid 2 with a predetermined substance capable of adjusting the resistivity of the liquid 2.

In FIG. 19, the liquid supply apparatus 111 of the immersion system 1 has a mixing device 150 for mixing the liquid 2 for supply to the supply port 8, with a predetermined substance capable of adjusting the resistivity of the liquid 2. In the present embodiment, for the substance for adjusting the resistivity of the liquid 2, carbon dioxide is used. The liquid supply apparatus 111 has a carbon dioxide supply apparatus 151 for supplying carbon dioxide to the mixing device 150. The mixing device 150 mixes the carbon dioxide supplied from the carbon dioxide supply apparatus 151 with liquid (extra pure water) 2 supplied from an extra pure water production apparatus 115 via a degassifier 116. The control apparatus 7 can adjust the amount of carbon dioxide supplied from the carbon dioxide supply apparatus 151 to the mixing device 150.

The mixing device 150 dissolves the carbon dioxide supplied from the carbon dioxide supply apparatus 151 in the liquid 2 degassed by the degassifier 116. By dissolving the carbon dioxide which adjusts the resistivity of the liquid 2 in the liquid 2, charging of the liquid 2 can be prevented or effectively suppressed.

The amount of carbon dioxide dissolved in the liquid 2 is appropriately adjusted to a level which can prevent charging of the liquid 2, and to a level where the size and the amount of bubbles attributable to the carbon dioxide dissolved in the liquid 2 is not greater than an allowable value. In other words, carbon dioxide not greater than an allowable value for the dissolved gas concentration is dissolved in the liquid 2. In order to prevent charging of the liquid 2, the amount of carbon dioxide dissolved in the liquid 2 may be extremely slight, and due to this carbon dioxide dissolved in the liquid 2, bubbles which produce defective exposure do not occur.

A resistivity meter (not shown in the figure) capable of measuring the resistivity of the liquid 2 is provided in the mixing device 150. The control apparatus 7 uses the resistivity meter to monitor the resistivity of the liquid 2 (the pure water in which carbon dioxide is dissolved) produced by the mixing device 150, and adjusts the amount of carbon dioxide supplied from the carbon dioxide supply apparatus 151 to the mixing device 150 so that the measured resistivity becomes a value within a predetermined range. As a result, inside the mixing device 150, carbon dioxide supplied from the carbon dioxide supply apparatus 151 is mixed in the liquid 2 supplied from the extra pure water production apparatus 115 (the degassifier 116), and dissolved, and liquid 2 of a desired resistivity is produced. That is, in the present embodiment, carbon dioxide which reduces the resistivity is introduced to the pure water and dissolved, and this is then supplied as liquid 2 from the supply port 8 to the optical path space K.

For mixing (dissolving) the carbon dioxide in the pure water, various types of methods such as a method of directly injecting carbon dioxide into the pure water, or a method of mixing carbon dioxide in the pure water via a hollow fiber membrane, can be adopted. Air containing carbon dioxide may be dissolved in the pure water. In the present embodiment, the resistivity of the liquid 2 is adjusted to not greater than 10 [MΩ·cm], and preferably 0.1 to 1.0 [MΩ·cm].

As described above, by dissolving carbon dioxide in the liquid 2 prior to supplying from the supply port 8, charging of the liquid 2 supplied to the optical path space K is prevented or effectively suppressed. Furthermore, since the carbon dioxide is contained in the liquid 2, then also while flowing in the supply pipe 113 or the supply passage 8L, charging of the liquid 2 is prevented. Furthermore, since charging of the liquid 2 is prevented by the carbon dioxide, even in the case where bubbles are generated in the liquid 2, charging of the bubbles is suppressed, so that these bubbles can be immediately reduced or eliminated, and the situation where bubbles remain in the liquid 2 can be suppressed.

Furthermore, by using the degassifier 116 to reduce the dissolved gas concentration in the liquid 2, in particular the dissolved oxygen concentration, the drop in the transmissivity of the liquid 2 with respect to the exposure light EL can be suppressed. Moreover, after sufficiently reducing the dissolved gas concentration in the liquid 2, by mixing (dissolving) carbon dioxide in a specified quantity in the liquid 2, the charging of the liquid 2 can be prevented while maintaining a desired transmissivity, and suppressing the generation of bubbles.

In the abovementioned eleventh embodiment, carbon dioxide is mixed (dissolved) in the liquid 2 before supplying from the supply port 8 of the immersion system 1 to the optical path space K of the exposure light EL. However in the case where for example a plurality of supply ports 8 are provided, prevention of charging of the liquid 2 filled in the optical path space K may be prevented by supplying a first liquid which does not contain carbon dioxide from the first supply port of the plurality of supply ports to the optical space K, supplying a second liquid which contains carbon dioxide from the second supply port to the optical path space K, and mixing the first liquid and the second liquid in the optical path space K. Furthermore, the liquid 2 and carbon dioxide may be mixed in the optical path space K.

In the abovementioned eleventh embodiment, the charge removal filter 114 is provided in the supply path, however this charge removal filter 114 may be omitted. If charging of the liquid 2 supplied to the supply port 8 can be prevented or suppressed by mixing (mixing) carbon dioxide with the liquid 2, then the charge removal filter 114 can be omitted.

### <Twelfth embodiment>

Next is a description of a twelfth embodiment with reference to FIG. 20 and FIG. 21. In the following description, components the same as or similar to those of the abovementioned embodiments are denoted by the same reference symbols, and description thereof is simplified or omitted. The characteristic part of the present embodiment is that ionized ionized liquid (ion water) is used as the predetermined substance capable of adjusting the resistivity of the liquid 2.

In FIG. 20, a liquid supply system 10 of an immersion system 1 includes; an extra pure water production apparatus 115 for producing extra pure water, a degassifier 116 for degassing the extra pure water produced by the extra pure water production apparatus 115, an ion water production apparatus 117 for ionizing the extra pure water degassed by the degassifier 116 to produce ion water 2A and 2B, a mixing apparatus 154 for mixing the ion water 2A and 2B produced by the ion water production apparatus 117 with extra pure water produced by the extra pure water production apparatus 115, and a supply pipe system 113. The supply pipe system 113 includes; a first supply pipe 113A, a second supply pipe 113B, a third supply pipe 113C, and a fourth supply pipe 113D. Inside of the nozzle member 6 is formed an internal passage (supply passage) 8L for connecting the supply port 8 to the supply pipe system 113 (third supply pipe 113 C).

The ion water production apparatus 117 ionizes the extra pure water and produces positive ion water 2A and negative ion water 2B. In the following description, the positive ion water 2A is appropriately called anode water 2A, and the negative ion water 2B is appropriately called cathode water 2B. Compared to the extra pure water before being ionized, the anode water 2A contains a large amount of hydrogen ions (H⁺), and the cathode water 2B contains a large amount of hydroxyl ions (OH⁻).

FIG. 21 is a schematic diagram showing an example of the ion water production apparatus 117. The ion water production apparatus 117has an electrolytic bath 130 to which the extra pure water is supplied. The interior of the electrolytic bath 130 is partitioned into first, second, and third chambers 131, 132 and 133 by means of diaphragms (ion exchange membranes) 136 and 137. The extra pure water is respectively supplied to the first, second and third chambers 131, 132 and 133. An anode 134 is arranged in the first chamber 131, and a cathode 135 is arranged in the second chamber 132. The third chamber 133 is provided between the first chamber 131 and the second chamber 132, and is filled for example with an ion exchange membrane. By supplying extra pure water to the first, second, and third chambers 131, 132 and 133, and applying a voltage to the anode 134 and the cathode 135, the anode water 2A is produced in the first chamber 131, and the cathode water 2B is produced in the second chamber 132. In this manner, the ion water production apparatus 117 can produce the electrolytic ion water 2A and 2B by electrolyzing the extra pure water. To the extra pure water supplied to the electrolytic bath 130, or the ion water sent from the electrolytic bath 130, a predetermined electrolyte may be added. The ion water production apparatus 117 shown in FIG. 21 is but one example, and provided the ion water 2A and 2B can be produced, an optional construction can be adopted.

Returning to FIG. 20, the anode water 2A produced by the ion water production apparatus 117 is supplied to the mixing apparatus 154 via the first supply pipe 113A. The cathode water 2B produced by the ion water production apparatus 117 is supplied to the mixing apparatus 154 via the second supply pipe 113B. The extra pure water produced by the extra pure water production apparatus 115 which has not been ionized is supplied to the mixing apparatus 154 via the fourth supply pipe 113D.

Part way along the first supply pipe 113A there is provided an adjustment mechanism 155A for adjusting the amount (supply per unit time) of the anode water 2A supplied to the mixing apparatus 154, which is produced in the ion water production apparatus 117. Similarly, part way along the second supply pipe 113B is provided an adjustment mechanism 155B for adjusting the amount (supply amount per unit time) of the cathode water 2B supplied to the mixing apparatus 154, which is produced by the ion water production apparatus 117. Moreover, part way along the fourth supply pipe 113D is provided an adjustment mechanism 155D for adjusting the amount (supply amount per unit time) of the extra pure water supplied to the mixing apparatus 154, which is produced by the extra pure water production apparatus 115. The adjustment mechanisms 155A, 155B and 155D include for example valve mechanisms. The control apparatus 7 uses the adjustment mechanisms 155A, 155B and 155D to make the amount of extra pure water supplied to the mixing apparatus 154 via the fourth supply pipe 113D greater than the amount of ion water 2A and 2B supplied to the mixing apparatus 154 via the first and second supply pipes 113A and 113B. That is, in the present embodiment, a small amount of ion water 2A and 2B is added to the extra pure water supplied to the mixing apparatus 154.

The mixing apparatus 154 mixes the anode water 2A, the cathode water 2B, and the extra pure water respectively supplied via the first supply pipe 113A, the second supply pipe 113B, and the fourth supply pipe 113D. The supply port 8 and the mixing apparatus 154 are connected via the third supply pipe 113C and the supply passage 8L. The liquid 2 produced by the mixing apparatus 154 is supplied to the supply port 8 via the third supply pipe 113 and the supply passage 8L. The liquid 2 produced by the mixing apparatus 154 is supplied from the supply port 8 to the optical path space K.

The extra pure water has a high electrically non conductivity and is easily charged (readily takes on static electricity). On the other hand, the ion water 2A and 2B has electroconductivity, and can adjust the resistivity of the extra pure water. The liquid supply system 10, even in the case where the extra pure water is charged, can remove the charge of the extra pure water by mixing the extra pure water with the ion water 2A and 2B in the mixing apparatus 154, and can prevent charging of the liquid 2 supplied to the optical path space K.

As described above, by mixing the ionized ion water 2A and 2B with the extra pure water, charging of the liquid 2 supplied from the supply port 8 to the optical path space K can be prevented. Consequently, even if bubbles occur in the liquid 2, charging of the bubbles is suppressed, and hence these bubbles can be immediately reduced or eliminated in the degassed liquid 2, and the situation where bubbles remain in the liquid 2 can be suppressed.

Furthermore, in the present embodiment, since the configuration is such that the extra pure water having electrical non conductivity is ionized, and manifests electroconductivity, then an additive for imparting conductivity to the extra pure water is not added. Consequently, the content of impurities in the liquid 2 supplied to the supply port 8 (the optical path space K) is very low, so that this does not cause a drop in light transmission of the liquid 2, an increase in temperature, or metal pollution, or the like. Hence liquid 2 for which the desired liquid properties are maintained, can be filled into the optical path space K, and the substrate P can be satisfactorily exposed.

In the abovementioned twelfth embodiment, the liquid supply system 10 respectively supplies anode water and cathode water. However if it is already known if the extra pure water is positively or negatively charged, then only one of the anode water and the cathode water need be supplied.

In the above mentioned twelfth embodiment, the extra pure water is mixed (added) before supplying from the supply port 8 of the immersion system 1 to the optical path space K of the exposure light EL. However in the case where for example a plurality of supply ports 8 are provided, charging of the liquid 2 filled in the optical path space K may be prevented by supplying extra pure water from the first supply port of these plurality of supply ports to the optical path space K, supplying ion water (at least one of anode water and cathode water) from the second supply port to the optical path space K, and mixing the extra pure water and the ion water in the optical path space K.

In the above mentioned twelfth embodiment, the charge removal filter 114 is provided in the supply path, however this charge removal filter 114 may be omitted. If the charging of the liquid 2 supplied to the supply port 8 can be prevented or effectively suppressed by mixing (adding) ion water with extra pure water which is non ion water, then the charge removal filter 114 can be omitted.

In the above mentioned twelfth embodiment, the exposure apparatus EX is configured with the ion water production apparatus 117. However ion water produced by an ion water production apparatus separated to the exposure apparatus EX, may be supplied to the optical path space K. That is, the exposure apparatus EX need not be provided with the ion water production apparatus. Similarly, at least one of the extra pure water production apparatus 115 and the degassifier 116 need not be provided.

Instead of the antistatic apparatus described for the abovementioned ninth through twelfth embodiments, a charge removal device (ionizer or the like) such as disclosed in Japanese Unexamined Patent Application, First Publication No. 2003-332218 may be arranged in the vicinity of the space on the image surface side of the projection optical system PL to prevent charging of the liquid 2. Of course the antistatic apparatus of the ninth through twelfth embodiments may be used together with the charge removal device such as the ionizer. Furthermore, in the above mentioned ninth through twelfth embodiments, the porous member 9T may be made from a conductor. In this case, at least one of the aforementioned charge removal filter 114, the conducting member 119, and the charge removal device (ionizer or the like) can be substituted, or these may be combined.

### <Thirteenth embodiment>

Next is a description of a thirteenth embodiment with reference to FIG. 22. In the following description, components the same as or similar to those of the abovementioned embodiments are denoted by the same reference symbols, and description thereof is simplified or omitted. In the abovementioned ninth through twelfth embodiments, the description was for where the liquid 2 for which charging has been prevented, is supplied to the optical path space K of the exposure light EL between the final optical element FL of the projection optical system PL which is closest to the image surface of the projection optical system PL, and the substrate P. However for example as disclosed in PCT International Patent Publication No. WO 2004/019128, the optical path on the object surface side (the mask M side) of the final optical element FL can also be filled with liquid.

In FIG. 22, an exposure apparatus EX is furnished with an immersion system 1' for supplying liquid 2 to between a final optical element FL, and a boundary optical element FL2 next closest to an image surface of a projection optical system PL, after the final optical element FL.

The immersion system 1' includes a supply port 8' for supplying liquid 2 to an optical path space K2 between the final optical element FL and the boundary optical element FL2, and a collection port 9' for recovering the liquid 2. The immersion system 1' has substantially the same construction as the aforementioned immersion system 1 described for the respective embodiment, and can fill the optical path space K2 with liquid 2 for which charging has been prevented. As a result, defective exposure attributable to bubbles in the liquid 2 supplied to the optical path space K2 of the exposure light can be suppressed.

As mentioned above, since charging of the bubbles in the liquid 2 is suppressed by preventing charging of the liquid 2, then even if bubbles are generated in the liquid 2, the situation where bubbles remain in the liquid 2 can be suppressed. That is to say, the antistatic device that prevents charging of the liquid 2 functions as an antistatic device that prevents charging of the bubbles in the liquid 2, so that the occurrence of the undesirable situation such as defective exposure attributable to bubbles in the liquid 2 can be suppressed.

In the present embodiment, an immersion system 1' is provided separate to the immersion system 1. However at least one part of the immersion system 1' may be used together with the immersion system 1. Furthermore, on a predetermined position of the optical path space K2, for example on at least one of the emitting surface of the boundary optical element FL2 and the incident surface of the final optical element FL, a conducting member for preventing charging of the liquid 2 may be provided, or the beforementioned charge removal device such as an ionizer may be provided in the vicinity of the optical path space K2. Moreover, a charge removal filter may be provided along the supply path of the liquid 2 in the immersion system 1'.

There is the possibility that the bubbles in the liquid 2 have an influence not only on the exposure of the substrate P but also on the various measurements performed via the liquid 2. However, as in the abovementioned ninth through thirteenth embodiments, since the situation where bubbles remain in the liquid 2 is suppressed by preventing charging of the bubbles, various measurements performed via the liquid 2 can also be executed with high accuracy. Consequently, exposure of the substrate P executed based on these measurements can also be favorably performed.

In the above mentioned respective embodiments, in the charge prevention for the liquid or the bubbles in the liquid, a small amount of charge is permitted on the liquid or the bubbles in the liquid, within a range which does not have an influence on the exposure. For example, the liquid or the bubbles in the liquid may be slightly charged provided this is within a range which does not produce disadvantages to the exposure process or the exposure apparatus. For example, the bubbles in the liquid may be eliminated by charge prevention so that the type, the number, and/or the volume of bubbles in the liquid are made within a tolerance. Similarly, regarding removal of charge from the liquid or from the bubbles in the liquid, a slight residual charge is permitted on the liquid or the bubbles in the liquid, within a range which does not have an influence on the exposure. For example, a small amount of charge may remain on the liquid or on the bubbles in the liquid provided this is within a range which does not produce disadvantages to the exposure process or the exposure apparatus. For example, the bubbles in the liquid may be eliminated by charge removal so that the type, the number, and/or the volume of the bubbles in the liquid is within a tolerance.

In the abovementioned respective embodiments, the construction of the immersion system 1 in which the optical path space K between the final optical element FL and the substrate P is filled with liquid 2, is not limited to the above configurations, and can adopt various configurations. For example, the configurations disclosed in U.S. Patent Publication No. 2004/0165159, and PCT International Patent Publication No. WO 2004/055803 may also be adopted.

Furthermore, the configuration of the immersion system 1' of the eighth and thirteenth embodiments is not limited to that described above, and may adopt various configurations. For example, the configuration disclosed in PCT International Patent Publication No. WO 2004/107048 may also be adopted.

The form of the immersion system (immersion space forming member) including the nozzle member 6 is not limited to that described above, and may use a nozzle member disclosed for example in PCT International Patent Publication No. WO 2004/086468 (corresponding to U.S. Patent Publication No. 2005/0280791A1), Japanese Unexamined Patent Application, First Publication No. 2004-289126 (corresponding U.S. Patent No. 6,952,253) and the like. More specifically, in the above mentioned respective embodiments, the bottom surface of the nozzle member 6 is set at substantially the same height (Z position) as the bottom surface (the emitting face of the projection optical system PL. However, for example the bottom surface of the nozzle member 6 may be set to the image surface side (the substrate side) from the bottom end face of the projection optical system PL. In this case, one part (the bottom end part) of the nozzle member 6 may be provided so as to slip into the bottom side of the projection optical system PL (the final optical element FL) so as not to obstruct the exposure light EL. Furthermore, in the abovementioned respective embodiments, the supply port 8 is provided on the bottom surface of the nozzle member 6. However the supply port 8 may be provided for example on the inside face (inclined face) of the nozzle member 6 facing the side face of the final optical element FL of the projection optical system PL.

In the above embodiments, pure water (extra pure water) is used as the liquid 2. Pure water has advantages in that it can be easily obtained in large quantity at semiconductor manufacturing plants, etc. and in that it has no adverse effects on the photoresist on the substrate P or on the optical elements (lenses), etc. In addition, pure water has no adverse effects on the environment and contains very few impurities, so one can also expect an action whereby the surface of the substrate P and the surface of the optical element provided on the front end surface of the projection optical system PL are cleaned.

In addition, the index of refraction n of pure water (water) with respect to exposure light EL with a wavelength of 193 nm is nearly 1.44, so in the case where ArF excimer laser light (193 nm wavelength) is used as the light source of the exposure light EL, it is possible to shorten the wavelength to 1/n, that is, approximately 134 nm on the substrate P, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

Note that the liquid 2 of the above embodiments is water (pure water), but it may be a liquid other than water. For example, if the light source of the exposure light EL is an F₂ laser, this F₂ laser light will not pass through water, so the liquid 2 may be, for example, a fluorocarbon fluid such as a perfluoropolyether (PFPE) or a fluorocarbon oil that an F₂ laser is able to pass through. In addition, it is also possible to use, as the liquid 2, liquids that have the transmittance with respect to the exposure light EL and whose refractive index are as high as possible and that are stable with respect to the photoresist coated on the projection optical system PL and the surface of the substrate P (for example, cedar oil).

Moreover as the liquid 2, a liquid with a refractive index of 1.6 to 1.8 may be used. Furthermore, the optical element FL may be formed from a quartz, or a material with a higher refractive index than that of quartz (for example, above 1.6). For the liquid LQ, various liquids, for example a supercritical liquid, can be used.

In the abovementioned embodiments, respective position information for the mask stage 3 and the substrate stage 4 is measured using an interference system (3L, 4L). However the invention is not limited to this and for example, an encoder system which detects a scale (grating) provided in each stage may be used. In this case, preferably a hybrid system is furnished with both of an interference system and an encoder system, and calibration of the measurement results of the encoder system is performed using the measurement results of the interference system. Moreover, position control of the stage may be performed using the interference system and the encoder system interchangeably, or using both.

In the above embodiments, an optical element FL is attached to the front end of the projection optical system PL, and this optical element FL can be used to adjust the optical characteristics, for example, the aberration (spherical aberration, coma aberration, etc.), of the projection optical system PL. Note that an optical plate used for the adjustment of the optical characteristics of the projection optical system PL may also be used as the optical element attached to the front end of the projection optical system PL. Or, it may also be a plane-parallel plate (cover glass or the like) through which the exposure light EL is able to pass.

In the case where the pressure between the substrate P and the optical element of the front end of the projection optical system PL arising from the flow of the liquid 2 is large, it is permissible to make that optical element not one that is replaceable but one that is firmly secured so that the optical element does not move due to that pressure.

In the above embodiments, the configuration is one in which a liquid 2 is filled between the projection optical system PL and the surface of the substrate P, but it may also be a configuration in which the liquid 2 is filled in a status in which a cover glass consisting of a plane-parallel plate is attached to the surface of the substrate P, for example.

It is to be noted that as for substrate P of each of the above-described embodiments, not only a semiconductor wafer for manufacturing a semiconductor device, but also a glass substrate for a display device, a ceramic wafer for a thin film magnetic head, or a master mask or reticle (synthetic quartz or silicon wafer), etc. can be used.

As for exposure apparatus EX, in addition to a scan type exposure apparatus (scanning stepper) in which while synchronously moving the mask M and the substrate P, the pattern of the mask M is scan-exposed, a step-and-repeat type projection exposure apparatus (stepper) in which the pattern of the mask M is exposed at one time in the condition that the mask M and the substrate P are stationary, and the substrate P is successively moved stepwise can be used.

Moreover, as for the exposure apparatus EX, the present invention can be applied to an exposure apparatus of a method in which a reduced image of a first pattern is exposed in a batch on the substrate P by using the projection optical system (for example, a refractive projection optical system having, for example, a reduction magnification of 1/8, which does not include a reflecting element), in the state with the first pattern and the substrate P being substantially stationary. In this case, the present invention can be also applied to a stitch type batch exposure apparatus in which after the reduced image of the first pattern is exposed in a batch, a reduced image of a second pattern is exposed in a batch on the substrate P, partially overlapped on the first pattern by using the projection optical system, in the state with the second pattern and the substrate P being substantially stationary. As the stitch type exposure apparatus, a step-and-stitch type exposure apparatus in which at least two patterns are transferred onto the substrate P in a partially overlapping manner, and the substrate P is sequentially moved can be used.

Moreover, in the above embodiment, an exposure apparatus furnished with a projection optical system PL was described an example, however the present invention can also be applied to an exposure apparatus and an exposure method which does not use a projection optical system PL. Even in the case where a projection optical system is not used, the exposure light can be shone onto the substrate via optical members such as a mask and lens, and an immersion region can be formed in a predetermined space between these optical elements and the substrate.

Furthermore, the present invention can also be applied to a twin stage type exposure apparatus furnished with a plurality of substrate stages, as disclosed for example in Japanese Unexamined Patent Application, First Publication No. H10-163099, Japanese Unexamined Patent Application, First Publication No. H10-214783 (corresponding to U.S. Patent No. 6,590,634), Published Japanese Translation No. 2000-505958 of PCT International Application (corresponding to U.S. Patent No. 5,696,411), and U.S. Patent No. 6,208,407.

Moreover, the present invention can also be applied to an exposure apparatus furnished with a substrate stage for holding a substrate, and a measurement stage on which is mounted a reference member formed with a reference mark, and various photoelectronic sensors, as disclosed for example in Japanese Unexamined Patent Application, First Publication No. H11-135400 (corresponding to PCT International Patent Publication No. WO 1999/23692), and Japanese Unexamined Patent Application, First Publication No. 2000-164504 (corresponding to U.S. Patent No. 6,897,963).

Furthermore, in the above embodiments, an exposure apparatus in which the liquid is locally filled in the space between the projection optical system PL and the substrate P is used. However, the present invention can be also applied to a liquid immersion exposure apparatus in which exposure is performed in a condition with the whole surface of the target exposure substrate immersed in a liquid, as disclosed for example in Japanese Unexamined Patent Application, First Publication No. H06-124873, Japanese Unexamined Patent Application, First Publication No. H10-303144, and U.S. Patent No. 5,825,043.

The types of exposure apparatuses EX are not limited to exposure apparatuses for semiconductor element manufacture that expose a semiconductor element pattern onto a substrate P, but are also widely applicable to exposure apparatuses for the manufacture of liquid crystal display elements and for the manufacture of displays, and exposure apparatuses for the manufacture of thin film magnetic heads, image pickup elements (CCD), micro machines, MEMS, DNA chips, and reticles or masks.

In the abovementioned embodiments, an optical transmission type mask formed with a predetermined shielding pattern (or phase pattern or dimming pattern) on an optical transmission substrate is used. However instead of this mask, for example as disclosed in U.S. Patent No. 6,778,257, an electronic mask (called a variable form mask; for example this includes a DMD (Digital Micro-mirror Device) as one type of non-radiative type image display element) for forming a transmission pattern or reflection pattern, or a light emitting pattern, based on electronic data of a pattern to be exposed may be used.

Furthermore the present invention can also be applied to an exposure apparatus (lithography system) which exposes a run-and-space pattern on a substrate P by forming interference fringes on the substrate P, as disclosed for example in PCT International Patent Publication No. WO 2001/035168.

Moreover, the present invention can also be applied to an exposure apparatus as disclosed for example in Published Japanese Translation No. 2004-519850 (corresponding U.S. Patent No. 6,611,316), which combines patterns of two masks on a substrate via a projection optical system, and double exposes a single shot region on the substrate at substantially the same time, using a single scan exposure light.

As far as is permitted by the law of the countries specified or selected in this patent application, the disclosures in all of the Japanese Patent Publications and U.S. Patents related to exposure apparatuses and the like cited in the above respective embodiments and modified examples, are incorporated herein by reference.

As described above, the exposure apparatus EX of the embodiments of this application is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

As shown in FIG. 23, microdevices such as semiconductor devices are manufactured by going through; a step 201 that performs microdevice function and performance design, a step 202 that creates the mask (reticle) based on this design step, a step 203 that manufactures the substrate that is the device base material, a step 204 including substrate processing steps such as a process that exposes the pattern on the mask onto a substrate by means of the exposure apparatus EX of the aforementioned embodiments, a process for developing the exposed substrate, and a process for heating (curing) and etching the developed substrate, a device assembly step (including treatment processes such as a dicing process, a bonding process and a packaging process) 205, and an inspection step 206, and so on.

### [Industrial Applicability]

According to the present invention, deterioration of the characteristics of the exposure apparatus can be suppressed, a substrate can be favorably exposed, and a device having a desired performance can be manufactured. Moreover, according to the present invention, defective exposure attributable to bubbles in the liquid can be suppressed, and the substrate can be satisfactorily exposed. Furthermore, a device having desired performance can be manufactured. In addition, the present invention is extremely useful in an exposure apparatus and method for manufacturing a wide range of product such as for example; semiconductor elements, liquid crystal display elements or displays, thin film magnetic heads, CCDs, micro machines, MEMS, DNA chips, and reticles (masks).

## Claims

1. An exposure apparatus for exposing a substrate, comprising:
a supply outlet that supplies a liquid to an optical path space of exposure light; and
a liquid supply apparatus that supplies an ionized ionic liquid to the supply outlet.

2. An exposure apparatus according to claim 1, wherein the liquid supply apparatus has an ionic liquid production apparatus that ionizes a liquid to produce the ionic liquid.

3. An exposure apparatus according to claim 1 or 2, wherein the liquid supply apparatus supplies both a positive ion liquid and a negative ion liquid.

4. An exposure apparatus according to claim 3, further comprising:
a first passage in which the positive ion liquid flows to the supply outlet, and
a second passage in which the negative ion liquid flows to the supply outlet.

5. An exposure apparatus according to claim 4, further comprising:
a mixing apparatus that mixes the positive ion liquid flowed from the first passage and the negative ion liquid flowed from the second passage, the mixing apparatus provided in a vicinity of the supply outlet; and
a third passage that connects the mixing apparatus and the supply outlet, wherein
a liquid produced in the mixing apparatus is supplied to the supply outlet via the third passage.

6. An exposure apparatus according to claim 5, further comprising:
a fourth passage that supplies a non ionized non ionic liquid to the mixing apparatus, wherein
a liquid produced in the mixing apparatus is supplied to the supply outlet via the third passage.

7. An exposure apparatus according to claim 1 or 2, further comprising:
a fifth passage in which the ionic liquid flows to the supply outlet; and
a sixth passage in which the non ionized non ionic liquid flows to the supply outlet.

8. An exposure apparatus according to claim 7, further comprising:
a mixing apparatus that mixes the ionic liquid flowed from the fifth passage and the non ionic liquid flowed from the sixth passage, the mixing apparatus provided in a vicinity of the supply outlet; and
a seventh passage that connects the mixing apparatus and the supply outlet, wherein
a liquid produced in the mixing apparatus is supplied to the supply outlet via the seventh passage.

9. An exposure apparatus according to claim 6 or 8, wherein an amount of the non ionic liquid supplied to the mixing apparatus is greater than that of the ionic liquid.

10. An exposure apparatus according to any one of claims 6, 8 and 9, further comprising:
a control apparatus that controls mixing in the mixing apparatus in response to a charge state of the non ionic liquid.

11. An exposure apparatus for exposing a substrate, comprising:
a first supply outlet that supplies a positive ion liquid to an optical path space of exposure light, and
a second supply outlet that supplies a negative ion liquid to the optical path space.

12. An exposure apparatus for exposing a substrate, comprising:
a first supply outlet that supplies an ionized ionic liquid to an optical path space of exposure light, and
a second supply outlet that supplies a non ionized non ionic liquid to the optical path space.

13. An exposure apparatus for exposing a substrate, comprising:
an immersion mechanism that fills an optical path space of exposure light with a liquid, and
a cleaning mechanism that cleans a predetermined member being in contact with the liquid, with an ionized ionic liquid.

14. An exposure apparatus according to claim 13, wherein the ionic liquid has a positive ion liquid.

15. An exposure apparatus according to claim 13 or 14, wherein the predetermined member has a passage forming member that forms a passage in which the liquid flows, the passage being connected to the optical path space.

16. An exposure apparatus according to claim 15, wherein the cleaning mechanism supplies the ionic liquid to the passage.

17. An exposure apparatus according to any one of claims 13 to 16, wherein the predetermined member has an optical member through which the exposure light passes.

18. An exposure apparatus according to any one of claims 1 to 17, wherein the liquid includes water.

19. A device manufacturing method that uses an exposure apparatus according to any one of claims 1 to 18.

20. An exposure method for exposing a substrate, comprising:
supplying an ionized ionic liquid to an optical path space of exposure light, and
irradiating the substrate with the exposure light via a liquid, the liquid being filled in the optical path space.

21. An exposure method according to claim 20, further comprising:
respectively supplying a positive ion liquid and a negative ion liquid to the optical path space, wherein
the positive ion liquid and the negative ion liquid are mixed immediately before being supplied to the optical path space.

22. An exposure method according to claim 20, further comprising:
respectively supplying a positive ion liquid and a negative ion liquid to the optical path space, wherein
the positive ion liquid and the negative ion liquid are mixed in the optical path space.

23. An exposure method according to any one of claims 20 to 22, further comprising:
supplying a non ionized non ionic liquid to the optical path space.

24. An exposure method according to claim 20, further comprising:
supplying a non ionized non ionic liquid to the optical path space, wherein
the ionic liquid and the non ionic liquid are mixed immediately before being supplied to the optical path space.

25. An exposure method according to claim 20, further comprising:
supplying a non ionized non ionic liquid to the optical path space, wherein
the ionic liquid and the non ionic liquid are mixed in the optical path space.

26. An exposure method according to any one of claims 20 to 25, wherein the liquid includes water.

27. A device manufacturing method that uses an exposure method according to any one of claims 20 to 26.

28. A maintenance method for an exposure apparatus that exposes a substrate, the method comprising:
cleaning a predetermined member with an ionized ionic liquid, the member being in contact with a liquid filled in an optical path space of exposure light.

29. A maintenance method according to claim 28, wherein the ionic liquid includes a positive ion liquid.

30. A maintenance method according to claim 28 or 29, wherein the liquid includes water.

31. An exposure apparatus for exposing a substrate, comprising:
an immersion mechanism that fills an optical path space of exposure light with a liquid, and
an antistatic device that prevents a charge of bubbles, the bubbles being generated in the liquid.

32. An exposure apparatus according to claim 31, wherein the antistatic device prevents the charge of bubbles by preventing a charge of the liquid, the bubbles being generated in the liquid.

33. An exposure apparatus for exposing a substrate, comprising:
an immersion mechanism that fills an optical path space of exposure light with a liquid, and
an antistatic device that prevents a charge of the liquid to thereby suppress defective exposure attributable to bubbles in the liquid.

34. An exposure apparatus according to claim 32 or 33, wherein the antistatic device prevents the charge of the liquid before being supplied to the optical path space by the immersion mechanism.

35. An exposure apparatus according to any one of claims 32 to 34, wherein the antistatic device prevents the charge of the liquid after being supplied to the optical path space by the immersion mechanism.

36. An exposure apparatus according to any one of claims 32 to 35, wherein the antistatic device comprises a charge removal device that removes the charge on the liquid.

37. An exposure apparatus according to any one of claims 32 to 36, wherein the antistatic device comprises an earthed conductive member provided at a position where the conductive member is in contact with the liquid.

38. An exposure apparatus according to any one of claims 32 to 37, wherein the antistatic device has a mixing device that mixes the liquid with a predetermined substance capable of adjusting resistivity of the liquid.

39. An exposure apparatus according to claim 38, wherein the predetermined substance includes carbon dioxide, and the mixing device dissolves the carbon dioxide in the liquid.

40. An exposure apparatus according to claim 38, wherein the predetermined substance includes an ionized ionic liquid.

41. An exposure apparatus according to any one of claims 31 to 40, wherein the immersion mechanism supplies a degassed liquid to the optical path space of the exposure light.

42. An exposure apparatus according to claim 41, wherein the antistatic device suppresses a situation where bubbles remain in the degassed liquid.

43. An exposure apparatus for exposing a substrate, comprising:
an immersion mechanism that fills an optical path space of exposure light with a liquid, and
a prevention apparatus that prevents defective exposure due to charged bubbles in the liquid.

44. An exposure apparatus according to claim 43, wherein the prevention apparatus prevents the defective exposure by preventing a charge of bubbles generated in the liquid.

45. An exposure apparatus according to claim 43 or 44, wherein the prevention apparatus prevents the defective exposure by preventing the liquid being charged.

46. A device manufacturing method that uses an exposure apparatus according to any one of claims 31 to 45.

47. An exposure method for exposing a substrate, comprising:
supplying a liquid to an optical path space of exposure light,
preventing bubbles in the liquid being charged to thereby suppress defective exposure due to bubbles in the liquid in the optical path space.

48. An exposure method according to claim 47, wherein the charging of bubbles in the liquid is prevented by preventing charging of the liquid.

49. An exposure method for exposing a substrate, comprising:
supplying a liquid to an optical path space of exposure light, and
preventing charging of the liquid to thereby suppress defective exposure due to bubbles in the liquid in the optical path space.

50. An exposure method according to any one of claims 47 to 49, further comprising:
degassing the liquid supplied to the optical path space to thereby suppress a situation where bubbles remain in the degassed liquid.

51. An exposure method for exposing a substrate, comprising:
supplying a liquid to an optical path space of exposure light, and
preventing charging of the liquid or bubbles in the liquid to thereby suppress a situation where bubbles remain in the liquid in the optical path space.

52. A device manufacturing method that uses the exposure method according to any one of claims 47 to 51.
